# EUROPÄISCHE PATENTSCHRIFT

(11) **EP 4 505 440 B1**
(45) Veröffentlichungstag und Bekanntmachung des Hinweises auf die Patenterteilung: **27.08.2025**
(21) Anmeldenummer: 23716570.9
(22) Anmeldetag: 04.04.2023
(51) Int. Cl.: G08C 17/02, F03D 17/00, G01R 31/54, H04Q 9/00, H02G 13/00

(54) **VORRICHTUNG, SYSTEM UND VERFAHREN ZUR DURCHFÜHRUNG EINER DURCHGANGSPRÜFUNG EINER ELEKTRISCHEN LEITUNG EINES OBJEKTS**
DEVICE, SYSTEM AND METHOD FOR CARRYING OUT A CONTINUITY CHECK ON AN ELECTRICAL LINE OF AN OBJECT
DISPOSITIF, SYSTÈME ET PROCÉDÉ POUR EFFECTUER UN CONTRÔLE DE CONTINUITÉ SUR UNE LIGNE ÉLECTRIQUE D'UN OBJET

(30) Priorität: 06.04.2022 DE 102022203443
(43) Veröffentlichungstag der Anmeldung: 12.02.2025
(73) Patentinhaber: TOP seven GmbH & Co. KG, 81477 München (DE)
(72) Erfinder: SENG, Ulrich, 82319 Starnberg (DE)
(74) Vertreter: Creutz, Andreas
(86) Internationale Anmeldenummer: PCT/EP2023/058876
(87) Internationale Veröffentlichungsnummer: WO 2023/194398

(56) Entgegenhaltungen:
- EP-A1- 3 211 226
- US-A1- 2013 336 786
- US-A1- 2019 279 498
- US-A1- 2022 065 228

## Beschreibung

### Technisches Gebiet

Ausführungsbeispiele gemäß der vorliegenden Erfindung befassen sich mit Vorrichtungen, Systemen und Verfahren zur Durchführung einer Durchgangsprüfung einer elektrischen Leitung eines Objekts.

### Hintergrund der Erfindung

Windkraftanlagen bilden bereits jetzt einen integralen Bestandteil erneuerbarer Energiequellen in einer Vielzahl von Ländern. Zum sicheren und verlässlichen Betrieb solcher Windkraftanlagen ist es daher wichtig, diese in regelmäßigen Abständen zu inspizieren. Bauartbedingt, z. B. durch stetig größer werdende Turmhöhen und Rotorblattlängen, sind Windkraftanlagen besonders durch Blitzeinschläge gefährdet. Um die Energie des Blitzes bei einem Blitzeinschlag ableiten zu können und um Beschädigungen an einer entsprechenden Windkraftanlage zu vermeiden, weisen Rotorblätter von Windkraftanlagen Blitzableiter auf. Diese Blitzableiter können aber beispielsweise durch die mechanische Belastung beim Betrieb der Windkraftanlage oder auch durch Umwelteinflüsse wie Oxidation beschädigt oder unbrauchbar werden. Die Blitzableiter sind dabei in der Regel im Inneren der Rotorblätter angeordnet, so dass eine Inspektion nicht ohne Weiteres möglich ist. Daher ist eine entsprechende Prüfung in der Regel mit hohen Kosten und mit hohem Aufwand verbunden.

US 2013/0336786 A1 offenbart ein System und Verfahren zur automatischen Überprüfung eines Blitzschutzsystems an einer Windturbine. Das System und Verfahren kann eine Windturbine mit einer Vielzahl von Rotorblättern umfassen, die an einer Nabe montiert sind, einen Blitzableiter an jedem der Rotorblätter, ein Blitzschutzsystem, das von jedem der Blitzableiter zu einem Erdungsgitter verläuft, und einen Leiter, der Teil eines Testsystems ist, das von mindestens der Innenseite der Nabe durch die Innenseite von mindestens einem der Rotorblätter verläuft und mit dem Blitzableiter verbunden ist, wobei der Leiter einen Stromkreis schließt, der vom Blitzableiter zum Erdungsgitter verläuft. Ein Teststromsignal kann in das Testsystem für einen zu testenden Zweig des Blitzschutzsystems eingeführt werden, und eine elektrische Kontinuität im Stromkreis kann unter Verwendung des Teststromsignals bestimmt werden.

US2022/0065228 A1 offenbart ein Überwachungssystem für ein Windturbinenblatt, wobei das Windturbinenblatt eine elektrisch leitende oder halbleitende Strukturkomponente und ein Blitzschutzsystem mit einem Ableiter umfasst, der elektrisch mit einem Blitzrezeptor verbunden ist, wobei der Ableiter durch einen Äquipotentialverbinder elektrisch mit der Strukturkomponente verbunden ist, so dass ein Netzwerk aus elektrischen Impedanzen gebildet wird, das die Strukturkomponente, den Äquipotentialverbinder und den Ableiter umfasst, wobei das hybride Überwachungssystem eine Sensorvorrichtung für das Netzwerk umfasst, die einen Sender zum Aussenden eines elektrischen Impulses in das Netzwerk über einen ersten Anschluss und einen Empfänger zum Empfangen eines Empfangsmusters des elektrischen Impulses vom Netzwerk über einen zweiten Anschluss sowie eine Auswertungsvorrichtung zum Auswerten des Empfangsmusters zum Bestimmen einer ersten Gesundheitsinformation bezüglich des Blitzschutzsystems und einer zweiten Gesundheitsinformation bezüglich der Strukturkomponente umfasst.

Daher besteht ein Bedarf nach einem Konzept, welches eine Durchgangsprüfung einer elektrischen Leitung eines Objekts, wie beispielsweise einer Windkraftanlage, mit geringer Komplexität und mit geringem Aufwand und damit mit geringen Kosten ermöglicht.

Ein solcher Bedarf kann von den Gegenständen der unabhängigen Patentansprüche erfüllt werden.

Erfindungsgemäße Weiterentwicklungen sind in den Unteransprüchen definiert.

### Zusammenfassung der Erfindung

Ausführungsbeispiele gemäß der vorliegenden Erfindung umfassen eine Vorrichtung zur Bereitstellung eines elektrischen Prüfsignals, zur Durchführung einer Durchgangsprüfung einer elektrischen Leitung (hierin auch als elektrischer Leiter bezeichnet) eines Objekts, umfassend ein Kommunikationsmodul, das ausgebildet ist, um ein Aktivierungssignal zu erhalten, um die Vorrichtung von einem passiven Betriebsmodus in einen aktiven Betriebsmodus zu versetzen, und um ein Deaktivierungssignal zu erhalten, um die Vorrichtung von dem aktiven Betriebsmodus in den passiven Betriebsmodus zu versetzen. Ferner umfasst die Vorrichtung einen Signalgenerator, der ausgebildet ist, um im aktiven Betriebsmodus das elektrische Prüfsignal zu erzeugen. Darüber hinaus umfasst die Vorrichtung eine Energiequelle, die ausgebildet ist, um das Kommunikationsmodul und den Signalgenerator mit Energie zu versorgen. Außerdem umfasst die Vorrichtung ein Einkopplungsmodul, das ausgebildet ist, um im aktiven Betriebsmodus das elektrische Prüfsignal in die elektrische Leitung des Objekts einzukoppeln.

Ausführungsbeispiele gemäß der vorliegenden Erfindung beruhen auf der Kernidee, ein Prüfsignal in die zu prüfende elektrische Leitung des Objekts einzukoppeln, um das Prüfsignal anschließend, beispielsweise nicht invasiv, mit einem Messgerät zu erfassen, um auf einen Zustand der Leitung des Objekts zurückzuschließen. Dazu umfasst die Vorrichtung den Signalgenerator, der dazu ausgebildet ist, um das Prüfsignal für das Einkopplungsmodul bereitzustellen. Die Erfinder haben erkannt, dass die Verwendung des Kommunikationsmoduls es ermöglicht, die Vorrichtung fernzusteuern, so dass insbesondere bei sehr großen Objekten der Prüfaufwand verringert werden kann. Beispielsweise im Fall einer Windkraftanlage kann es so nicht notwendig sein, dass ein Anlagentester oder eine Anlagentesterin den Turm der Windkraftanlage bis zum Einspeiseort des elektrischen Prüfsignals erklimmen muss, um die Vorrichtung zu aktivieren, oder in anderen Worten, in einen aktiven Betriebsmodus zu versetzten. Somit kann ermöglicht werden, dass eine erfindungsgemäße Vorrichtung auch fest mit dem Objekt verbunden werden kann, um die Vorrichtung lediglich im Zuge einer Inspektion zu aktivieren und anschließend wieder zu deaktivieren.

Weitere Ausführungsbeispiele gemäß der vorliegenden Erfindung umfassen ein Verfahren zur Durchführung einer Durchgangsprüfung einer elektrischen Leitung eines Objekts, umfassend Versorgen eines Kommunikationsmoduls mit Energie einer Energiequelle und Erhalten eines Aktivierungssignals mittels des Kommunikationsmoduls, um ausgehend von einem passiven Betriebsmodus in einen aktiven Betriebsmodus zu wechseln. Ferner umfasst das Verfahren ein Versorgen eines Signalgenerators im aktiven Betriebsmodus mit Energie der Energiequelle und ein Erzeugen eines elektrischen Prüfsignals im aktiven Betriebsmodus mittels des Signalgenerators. Darüber hinaus umfasst das Verfahren ein Einkoppeln des elektrische Prüfsignals im aktiven Betriebsmodus in die elektrische Leitung des Objekts und ein Erhalten eines Deaktivierungssignals mittels des Kommunikationsmoduls, um vom aktiven Betriebsmodus in den passiven Betriebsmodus zu wechseln.

Das zuvor beschriebene Verfahren beruht dabei auf denselben Überlegungen wie die zuvor beschriebene Vorrichtung. Die Vorrichtung kann entsprechend mit allen Merkmalen und Funktionalitäten, welche im Zusammenhang mit der Vorrichtung beschrieben werden, sowohl einzeln als auch in Kombination, ergänzt werden.

Gemäß weiteren Ausführungsbeispielen der vorliegenden Erfindung ist das Kommunikationsmodul dazu ausgebildet, um das Aktivierungssignal und/oder das Deaktivierungssignal drahtlos zu erhalten. Die Erfinder haben erkannt, dass eine drahtlose Kommunikation mit dem Kommunikationsmodul eine hohe Flexibilität in der Bereitstellung des elektrischen Prüfsignals ermöglicht. Insbesondere bei sehr großen Objekten kann ein Ort, an dem das Prüfsignal in die Leitung des Objekts eingespeist wird, von einem Ort, an dem das Prüfsignal erfasst werden muss, weit entfernt liegen. Somit kann beispielsweise insbesondere bei schwer zugänglichen Objekten, wie beispielsweise einer Windkraftanlage, ausgehend von verschiedenen Positionen am Objekt die Vorrichtung in den aktiven Betriebsmodus versetzt werden, um das Prüfsignal in die Leitung einzukoppeln. Somit kann beispielsweise ein Kletterer mit einem tragbaren Messgerät alleine am Rotorblatt befindlich das Prüfsignal aktivieren, um das elektrische Prüfsignal in dem Blitzableiter des Rotorblattes zu erfassen. Somit ist beispielsweise keine zweite Person nötig, die die Vorrichtung steuert und sich mit dem Kletterer abstimmen muss. Ferner ermöglicht eine drahtlose Kommunikation auch die Verwendung automatisierter Prüfverfahren. Beispielweise kann eine Drohne, welche das Objekt abfliegt, mittels drahtloser Kommunikation die Vorrichtung aktivieren, um das Prüfsignal in die Leitung des Objekts einzukoppeln, um das elektrische Prüfsignal anschließend zu messen und nach Abschluss der Messung oder der Inspektion die Vorrichtung wieder mittels drahtloser Kommunikation zu deaktivieren. Bei dem Kommunikationsmodul kann es sich beispielsweise um ein Funkmodul handeln.

Gemäß weiteren Ausführungsbeispielen der vorliegenden Erfindung ist das Kommunikationsmodul dazu ausgebildet, um das Aktivierungssignal oder das Deaktivierungssignal drahtgebunden zu erhalten. In einem Fall, in dem die Vorrichtung beispielsweise fest an dem Objekt angebracht ist, kann das Objekt beispielsweise über eine drahtgebundene Kommunikationsleitung zu der Vorrichtung verfügen, so dass bspw. von einem leicht zugänglichen Ort an oder in dem Objekt aus eine Anschlussmöglichkeit bereitgestellt werden kann, um die Vorrichtung zu steuern. Beispielsweise im Fall einer autonomen Drohne (optional auch bei einer händisch gesteuerten Drohne oder bei einer semi-autonomen Drohne), welche zur Inspektion des Objekts und zur Messung des Prüfsignals in der elektrischen Leitung ausgebildet ist, kann somit beispielsweise am Fuß der Anlage mit einer Recheneinheit die Drohne gesteuert oder gestartet werden und zugleich die Vorrichtung mittels eines Anschlusses an dem Objekt in den aktiven Betriebsmodus versetzt werden. Ferner kann eine drahtgebundene Kommunikation störungssicherer sein als beispielsweise eine drahtlose Kommunikation. Ferner kann gemäß Ausführungsbeispielen die Vorrichtung bspw. per USB Anschluss, drahtgebunden konfiguriert werden.

Gemäß weiteren Ausführungsbeispielen der vorliegenden Erfindung weist die Energiequelle zumindest eines aus einem austauschbaren Energiespeicher und/oder einem wiederaufladbaren Energiespeicher auf. Alternativ oder zusätzlich ist die Energiequelle dazu ausgebildet, um mit einer externen Leistungsversorgung gekoppelt zu werden. Die Erfinder haben erkannt, dass durch die Verwendung eines Energiespeichers die Vorrichtung zumindest näherungsweise oder zeitweise autark betrieben oder verwendet werden kann. So kann die Vorrichtung beispielsweise baulich mit dem Objekt verbunden werden, um mittels des Kommunikationsmoduls zur Durchführung der Durchgangsprüfung bei einer Inspektion aktiviert zu werden. Dementsprechend muss es also nicht notwendig sein, dass zuvor die Vorrichtung extra mit Energie versorgt werden muss, indem z. B. händisch ein Kabel an die Vorrichtung angeschlossen wird. Konkret für den Fall einer Windkraftanlage kann also beispielsweise die Vorrichtung in der Nähe des Rotorblattansatzes, beispielsweise in der Gondel, verbaut sein, und beispielsweise mittels einer Drohne per drahtloser Kommunikation aktiviert zu werden, wobei sowohl die Kommunikation als auch die Erzeugung des Prüfsignals basierend auf Energie, welche von einem austauschbaren oder wiederaufladbaren Energiespeicher bereitgestellt wird, ermöglicht werden kann. Durch entsprechend dimensionierte Energiespeicher kann so beispielsweise im Zuge weiterer routinemäßiger Inspektion (bspw. in größeren Zeitintervallen als Zeitintervalle zwischen Durchgangsprüfungen) z. B. der entsprechenden Gondel der Energiespeicher in regelmäßigen Intervallen ausgetauscht oder wiederaufgeladen werden. Somit kann Arbeits- und entsprechend auch Zeitaufwand optimiert und eingespart werden. Dabei sei darauf hingewiesen, dass diese Vorteile nicht nur bei Windkraftanlagen zum Tragen kommen, sondern insbesondere bei jedem großen Objekt, bei dem eine entsprechende Vorrichtung zur Durchgangsprüfung eines Leiters beispielsweise an einem schwer zugänglichen Ort verbaut werden muss.

Ferner haben die Erfinder jedoch auch erkannt, dass beispielsweise bei Objekten, die zur Energieerzeugung dienen oder die, bspw. konstant, mit Energie versorgt werden, die Energiequelle auch dazu ausgebildet sein kann, um mit einer externen Leistungsversorgung, beispielweise einer Leistungsversorgung des Objekts, gekoppelt zu werden. Somit kann ebenfalls eine effiziente Methode der Energieversorgung für die Vorrichtung gegeben sein, um auch über lange Zeiträume und zusätzlichen Aufwand die Vorrichtung zur Durchgangsprüfung verwenden zu können.

Gemäß weiteren Ausführungsbeispielen der vorliegenden Erfindung ist das Einkopplungsmodul dazu ausgebildet, um im aktiven Betriebsmodus das elektrische Prüfsignal induktiv in die elektrische Leitung des Objekts einzukoppeln. Alternativ oder zusätzlich ist das Entkopplungsmodul dazu ausgebildet, um im aktiven Betriebsmodus das elektrische Prüfsignal kapazitiv in die elektrische Leitung des Objekts einzukoppeln. Die Erfinder haben erkannt, dass eine induktive oder kapazitive Einkopplung des Prüfsignals eine besonders vorteilhafte Leitungsprüfung ermöglicht. Zum einen können so Objekte mittels der Vorrichtung nachgerüstet werden, ohne beispielsweise schwer zugängliche Leiter, die geprüft werden müssen, direkt elektrisch kontaktieren zu müssen. Zum anderen kann eine derartige Einkopplung auch insbesondere Vorteile im Hinblick auf Objekte mit beweglichen elektrischen Leitungen aufweisen, bei denen eine entsprechende Durchgangsprüfung beispielsweise nur in bestimmten Stellungen oder Ausrichtungen der elektrischen Leitung möglich ist, wobei es in einem Regelbetrieb des Objekts beispielsweise vorteilhaft sein kann, dass sich die Leitung relativ zu der Vorrichtung zur Durchgangsprüfung bewegen kann.

Gemäß weiteren Ausführungsbeispielen der vorliegenden Erfindung ist das Einkopplungsmodul dazu ausgebildet, um galvanisch getrennt so an der elektrischen Leitung befestigt zu werden, dass die Vorrichtung vor einer Spannungs- und/oder Stromspitze auf der elektrischen Leitung im Wesentlichen geschützt ist. Insbesondere sehr große Objekte können anfällig für Blitzeinschläge sein, welche zu hohen Spannungen und/oder Strömen auf elektrischen Leitungen innerhalb des Objekts führen können. Durch eine entsprechend galvanisch getrennte Kopplung der Vorrichtung mittels des Einkopplungsmoduls mit der Leitung kann eine Beschädigung oder Zerstörung der Vorrichtung beispielsweise bei einem solchen Blitzeinschlag verhindert werden.

Gemäß weiteren Ausführungsbeispielen der vorliegenden Erfindung weist das Einkopplungsmodul eine elektrisch schaltbare ohmsche Verbindung mit der Leitung des Objekts auf, um im aktiven Betriebsmodus das elektrische Prüfsignal in die elektrische Leitung des Objekts einzukoppeln. Die Erfinder haben erkannt, dass in einigen Fällen, beispielsweise wenn die Vorrichtung baulich mit dem Objekt verbunden ist, das Prüfsignal auch über eine schaltbare ohmsche Verbindung in das Objekt bzw. den Leiter des Objekts eingekoppelt werden kann. Somit kann beispielsweise eine besonders störungsrobuste und direkte Prüfsignaleinkopplung stattfinden, beispielsweise für sehr starke elektrische Prüfsignale, also beispielsweise mit hohen Spannungen oder hohen Strömen. Durch die Verwendung einer schaltbaren ohmschen Verbindung kann eine entsprechende Entkopplung gewährleistet werden, um beispielsweise auch gegenüber Blitzeinschlägen abgesichert zu sein. Bei der ohmschen Einkopplung können bspw. insbesondere auch Prüfsignale umfassend niederfrequente Signale oder getaktete niederfrequente Signale verwendet werden.

Gemäß weiteren Ausführungsbeispielen der vorliegenden Erfindung ist die Vorrichtung dazu ausgebildet, um im passiven Betriebsmodus einen Energieverbrauch der Vorrichtung im Vergleich zum aktiven Betriebsmodus zu verringern, und um das Kommunikationsmodul im passiven Betriebsmodus in zeitlichen Abständen für eine vorbestimmte Dauer zum Erhalten des Aktivierungssignals zu aktiveren. Die Erfinder haben erkannt, dass mittels eines solchen passiven Betriebsmodus Energie in Zeiträumen gespart werden kann, in denen keine Inspektion, also beispielsweise eine Durchgangsprüfung einer Leitung des Objekts, notwendig oder vorgesehen ist. Entsprechend kann beispielsweise im Hinblick auf austauschbare oder wiederaufladbare Energiespeicher ein Zeitraum bis zur Notwendigkeit eines Austauschs oder einer Wiederaufladung verlängert werden. Ferner haben die Erfinder erkannt, dass durch eine zyklische Aktivierung des Kommunikationsmoduls zum Erhalten des Aktivierungssignals die Vorrichtung mit geringem Aufwand in den aktiven Betriebsmodus für die Inspektion versetzt werden kann. Somit muss es also beispielsweise nicht notwendig sein, dass eine Person händisch die Vorrichtung aktivieren muss, um eine Inspektion zu starten.

Gemäß weiteren Ausführungsbeispielen der vorliegenden Erfindung weist die Energiequelle zumindest eines aus einem austauschbaren Energiespeicher und/oder einem wiederaufladbaren Energiespeicher auf und das Kommunikationsmodul ist dazu ausgebildet, um im aktiven Betriebsmodus einen Ladezustand des Energiespeichers zu übermitteln. Die Erfinder haben erkannt, dass somit eine Zuverlässigkeit der Vorrichtung verbessert werden kann. Entsprechend kann während einer Inspektion der Ladezustand des Energiespeichers überwacht werden, um zum einen eine Information darüber zu erhalten, ob die Inspektion mit dem verbleibenden Energievorrat durchgeführt werden kann, um beispielsweise einen Alterungszustand des Energiespeichers zu bestimmen, beispielsweise über ein Energiedelta seit der letzten Inspektion mit Übermittlung des vorherigen Ladezustandes, und/oder um einen Austausch oder ein Wiederaufladen des Energiespeichers zu planen.

Gemäß weiteren Ausführungsbeispielen der vorliegenden Erfindung ist das Kommunikationsmodul dazu ausgebildet, um eine Information über den Betriebszustand der Vorrichtung zu übermitteln. Somit kann die Vorrichtung beispielsweise nach Erhalt eines Aktivierungssignals rückmelden, dass die Vorrichtung das Aktivierungssignal erhalten hat, indem eine Information über den aktiven Betriebszustand übermittelt wird. Somit kann beispielsweise sichergestellt werden, dass die Vorrichtung bereit zum Erzeugen des Prüfsignals ist, bevor eine beispielsweise aufwändige Messung an der Leitung des Objekts vorbereitet wird.

Gemäß weiteren Ausführungsbeispielen der vorliegenden Erfindung ist das elektrische Prüfsignal ein Hochfrequenzsignal, ein Funkfrequenzsignal, ein Niederfrequenzsignal und/oder ein getaktetes Niederfrequenzsignal. Die Erfinder haben erkannt, dass bspw. ein Hochfrequenzsignal in vielen Fällen eine effiziente Durchgangsprüfung einer elektrischen Leitung eines Objekts ermöglicht. Somit kann beispielsweise ein abgestrahltes elektrisches oder elektromagnetisches Feld des Hochfrequenzsignals in der elektrischen Leitung auch aus einem gewissen Abstand von der elektrischen Leitung detektiert werden.

Beispielsweise in einem Rotorblatt einer Windkraftanlage können mehrere Verbindungen (bspw. Verschraubungen) im Verlauf der Ableitung (bspw. Blitzableitung) vorhanden sein. An diesen Stellen treffen Metalloberflächen aufeinander und bilden Kontaktverbindungen zwischen gelegentlich stromführenden Leitern. Bei Anwesenheit von Sauerstoff oder anderen Gasen mit chemisch aggressiven Wirkungen reagiert die Oberfläche von unedlen Metallen: Es können sich Schichten von Oxiden, Sulfiden, Chloriden und ähnlichen Stoffen bilden. Ferner kann sich unter den Normverhältnissen des atmosphärischen Umfelds eine Wasserhaut bilden.

Schließlich sind bauseitig nicht verhinderbare Verschmutzungen mit Öl, Fett und Staub hinzuzurechnen. Diese Veränderungen bzw. Beeinträchtigungen können insgesamt zu Fremdschichten auf dem Material führen, welche den Stromübergang erheblich stören oder ihn vollständig unterbrechen können.

Die Erfinder haben erkannt, dass die Verwendung eines Hochfrequenzsignals eine differenzierte Auswertung ermöglicht, um zwischen für einen Blitzeinschlag problematischen Stellen und lediglich geringfügig oxidierten oder unterbrochenen Stellen eines Blitzableiters zu unterscheiden.

Bspw. kann also die erfindungsgemäße Prüfmethode, zur Prüfung des Durchgangs der Ableitungen in den Rotorblättern ein elektrisch induziertes Feld verwenden, das in der Lage ist, die beschriebenen Anlauf- und Fremdschichten durch Induktion zu überbrücken.

Gemäß weiteren Ausführungsbeispielen der vorliegenden Erfindung ist der Signalgenerator dazu ausgebildet, um eine Impedanzanpassung an die elektrische Leitung zu ermöglichen. Die Erfinder haben erkannt, dass somit eine besonders effiziente Einkopplung in die elektrische Leitung ermöglicht werden kann. Ferner kann der Signalgenerator dazu ausgebildet sein, eine Kalibrierung beispielsweise für unterschiedliche elektrische Leitungen unterschiedlicher Objekte durchzuführen, um eine entsprechende Impedanzanpassung möglichst effizient durchzuführen.

Konkret kann also bspw. der Generatorausgang des Signalgenerators innerhalb der Vorrichtung z.B. in gewissen Grenzen die Impedanzanpassung (Abstrahlung) vornehmen, d.h. es kann bspw. zumindest näherungsweise ein optimierter Wert abhängig vom System, also bspw. dem Leiter des Objekts eingestellt werden.

Gemäß weiteren Ausführungsbeispielen der vorliegenden Erfindung weist die Vorrichtung zumindest eine Schutzdiode auf und die Schutzdiode ist dazu ausgebildet, um die Vorrichtung vor einer Spannungs- und/oder Stromspitze auf der elektrischen Leitung zu schützen. Die Schutzdiode kann beispielsweise dazu ausgebildet sein, eine Überspannung oder einen Überstrom abzuleiten, oder einen entsprechenden Überstrom oder eine entsprechende Überspannung zu dissipieren. Somit kann beispielsweise ein Blitzeinschlag oder eine starke elektrische Rückkopplung z. B. bei Objekten, die zur Erzeugung von großen Energiemengen ausgebildet sind, ermöglicht werden.

Die Schutzdiode kann bspw. eine bipolaren Transil Diode sein. Die Diode braucht bspw. keine Ableitung gegen Masse, sondern kann intern parallel zu dem Einkopplungsmodul, also bspw. der Induktionsspule, angebracht werden und so Überspannungsimpulse bspw. bei einem möglichen Blitzeinschlag abfangen. Bspw. kann also das Einkopplungsmodul mittels der Schutzdiode überbrückt werden.

Dieser Schutz gegen Blitzeischlag kann, bspw. nur, mit erfindungsgemäßen Lösungen (z.B. mit induktiver Einkopplung mit galvanischer Trennung, z.B. im Fall einer Induktionsspule - keine ohmsche Verbindung) möglich sein.

Dies ermöglicht Vorteile gegenüber einer bspw. ohmschen Signaleinspeisung (z.B. mittels Unterbrechung der Leitung und Einspeisung auf beiden Seiten), da dabei unter Umständen bei Blitzschlag die Gefahr der Zerstörung bzw. Blitzschutz nicht mehr gewährleistet sein kann.

Bei der Schutzdiode kann es sich ganz allgemein um einen "transient voltage-supression" (TVS), bspw. eine Suppressordiode, bspw. eine Transildiode oder einen Thyrector handeln. Die Schutzdiode kann also bspw. eine elektrische Komponenten sein, durch welche elektrische Schaltungen, also bspw. die erfindungsgemäße Vorrichtung, bspw. insbesondere der Signalgenerator und das Kommunikationsmodul und entsprechende Leitungen der Vorrichtung, vor Spannungspeaks, die in Leitungen induziert werden, geschützt werden können.

Eine solche Schutzdiode kann bspw. einen Überstrom shunten (Der Strom des Impulses kann bspw. an dem zu schützenden Bauteil vorbei geführt werden, bspw. basierend auf einer parallelen Verschaltung), wenn eine induzierte Spannung bspw. ein Durchbruchspannung, bspw. eine Lawinendurchbruchspannung, überschreitet. Die Schutzdiode kann bspw. eine Klemmschaltung (clamping device) sein, und kann dazu ausgebildet sein, um Überspannungen oberhalb einer Durchbruchspannung zu unterdrücken.

Die Schutzdiode kann sich bspw. automatisch zurücksetzen, wenn die Überspannung nicht mehr anliegt, und kann bspw. sehr viel transiente Energie intern absorbieren, z.B. mehr als eine ähnlich eingestufte Klemmschaltung (crowbar device). Die Schutzdiode kann dabei bspw. uni- oder bidirektional ausgeführt sein.

Eine unidirektionale Diode kann dabei als Gleichrichter in Vorwärtsrichtung wirken, wie einen Lawinendiode, kann aber dazu ausgebildet und getestet sein, um sehr große Stromspitzen zu handhaben.

Bidirektionale TVS Dioden können mittels zweier gegenseitig entgegengesetzten Lawinnendioden repräsentiert werden, die miteinander in Reihe geschaltet und mit dem zu schützenden Bauteil parallel geschaltet sind. Diese Art der Repräsentation kann jedoch bspw. nur schematisch korrekt sein, physisch können derartige Vorrichtungen als einzelne Komponente gefertigt sein.

Gemäß weiteren Ausführungsbeispielen der vorliegenden Erfindung ist die Schutzdiode eine Suppressordiode und die Suppressordiode ist parallel zum Einkopplungsmodul verschaltet. Bei der Suppressordiode kann es sich beispielsweise um eine bipolare Transildiode handeln. Eine solche Diode braucht beispielsweise keine Ableitung gegen Masse, sondern kann in der Vorrichtung intern parallel zum Einkopplungsmodul, beispielsweise einer Induktionsspule, angebracht werden, und kann so Überspannungsimpulse beispielsweise bei einem möglichen Blitzeinschlag abfangen.

Gemäß weiteren Ausführungsbeispielen der vorliegenden Erfindung kann das Prüfsignal eine aufmodulierte Signalkennung aufweisen. Die Erfinder haben erkannt, dass somit eine Robustheit der Durchgangsprüfung verbessert werden kann, beispielsweise indem durch die aufmodulierte Kennung das Prüfsignal bei einem Erfassen des Prüfsignals von anderen Signalen oder Störsignalen unterschieden werden kann.

Gemäß weiteren Ausführungsbeispielen der vorliegenden Erfindung ist das Objekt eine Windkraftanlage mit einer Mehrzahl von Rotorblättern, wobei die Rotorblätter jeweils elektrische Leitungen in Form von Blitzableitern aufweisen. Ferner ist die elektrische Leitung ein Blitzableiter eines Rotorblattes der Windkraftanlage. Wie bereits zuvor erläutert, hat die erfindungsgemäße Vorrichtung insbesondere große Vorteile im Hinblick auf eine Durchgangsprüfung eines Blitzableiters eines Rotorblattes einer Windkraftanlage.

So kann eine derartige Inspektion beispielsweise durch eine einzelne Person durchgeführt werden, welche die Vorrichtung drahtgebunden oder drahtlos vom Boden aus aktiviert, um ein Prüfsignal in einen Blitzableiter eines Rotorblattes einzukoppeln. Anschließend kann beispielsweise mittels einer Drohne das Rotorblatt abgeflogen werden und das Prüfsignal aufgenommen werden. Somit kann auf einen Zustand des Blitzableiters zurückgeschlossen werden. Anschließend kann die Vorrichtung entsprechend auch wieder deaktiviert werden. Somit kann mit geringem Personal- und Zeitaufwand eine Durchgangsprüfung bereitgestellt werden.

Dabei kann die Vorrichtung beispielsweise in der Nabe, im Flansch, oder in einem Rotorblatt der Windkraftanlage angeordnet sein. Das Prüfsignal kann beispielsweise effizient an einem Ansatz des Rotorblattes in den Blitzableiter des Rotorblattes eingekoppelt werden.

Alternativ kann auch beispielsweise die Drohne beim Abfliegen der Windkraftanlage das Aktivierungssignal für die Vorrichtung bereitstellen. Somit kann es beispielsweise nicht mehr notwendig sein, dass mehrere Servicetechniker, beispielsweise aus Sicherheitsgründen oder gesetzlichen Vorgaben, in die Nabe des Flügelansatzes klettern müssen, um eine entsprechende Vorrichtung zu aktivieren. Ferner kann die entsprechende Vorrichtung auch fest mit der Windkraftanlage verbunden sein, so dass eine entsprechende Vorrichtung noch nicht einmal mehr extra für die Inspektion befestigt werden muss. Bei dem Einkopplungsmodul kann es sich beispielsweise um eine Zange bspw. eine Induktionszange oder einen Ring, bspw. einen Induktionsring, handeln, die oder der an einem entsprechenden Blitzschutzkabel befestigt wird oder fest baulich befestigt ist.

Gemäß weiteren Ausführungsbeispielen der vorliegenden Erfindung ist das Einkopplungsmodul dazu ausgebildet, um am Blitzableiter eines Rotorblattes befestigt zu werden und/oder um in den Blitzableiter des Rotorblattes integriert zu werden. Alternativ oder zusätzlich ist das Einkopplungsmodul dazu ausgebildet, um in einer Zuleitung zum Rotorblatt befestigt und/oder in die Zuleitung integriert zu werden und/oder um in ein Rotorblatt integriert und/oder um in einem Rotorblatt befestigt zu werden. Ausführungsbeispiele der vorliegenden Erfindung sind nicht auf einer spezielle Befestigung des Einkopplungsmoduls am Blitzableiter eingeschränkt. Je nach Bauart der Windkraftanlage oder beispielsweise, ob die Vorrichtung für die Windkraftanlage nachgerüstet wird oder schon direkt bei der Herstellung der Windkraftanlage vorgesehen ist, kann ein entsprechendes Einkopplungsmodul mit einer hohen Flexibilität verwendet werden.

Gemäß weiteren Ausführungsbeispielen der vorliegenden Erfindung weist die Vorrichtung eine, der Mehrzahl von Rotorblättern entsprechende, Mehrzahl von Einkopplungsmodulen auf, wobei ein jeweiliges Einkopplungsmodul dazu ausgebildet ist, um das elektrische Prüfsignal zur Durchgangsprüfung eines jeweiligen Blitzableiters in ein jeweiliges Rotorblatt einzukoppeln. Somit können also beispielsweise mit einer einzigen Vorrichtung eine Vielzahl von Blitzableitern von Rotorblättern eines Windrads bzw. einer Windkraftanlage geprüft werden. Dabei kann das Prüfsignal beispielsweise nacheinander in die verschiedenen Blitzableiter eingekoppelt werden, so dass beispielsweise eine einzelne Drohne nacheinander ein entsprechendes Rotorblatt mit eingekoppeltem Prüfsignal abfliegt, um das Prüfsignal zu erfassen. Alternativ kann jedoch ebenfalls das Prüfsignal gleichzeitig in die Mehrzahl von Rotorblättern eingekoppelt werden, beispielsweise um gleichzeitig z. B. mit einer Vielzahl von Drohnen, besonders zeiteffizient die Blitzableiter der Rotorblätter zu überprüfen. Dabei können die Einkopplungsmodule beispielsweise von dem einen Signalgenerator gespeist werden.

Gemäß weiteren Ausführungsbeispielen der vorliegenden Erfindung weist die Vorrichtung eine, der Mehrzahl von Rotorblättern entsprechende, Mehrzahl von Einkopplungsmodulen auf, wobei ein jeweiliges Einkopplungsmodul dazu ausgebildet ist, um ein jeweiliges elektrisches Prüfsignal zur Durchgangsprüfung eines jeweiligen Blitzableiters in ein jeweiliges Rotorblatt einzukoppeln. Ferner weist die Vorrichtung eine, der Mehrzahl von Einkopplungsmodulen entsprechende, Mehrzahl von Signalgeneratoren auf, wobei ein jeweiliger Signalgenerator der Mehrzahl von Signalgeneratoren dazu ausgebildet ist, um im aktiven Betriebsmodus das jeweilige elektrische Prüfsignal zur Einkopplung in einen jeweiligen Blitzableiter zu erzeugen. Einfach ausgedrückt kann für jedes Einkopplungsmodul der Vorrichtung ein zugehöriger Signalgenerator vorhanden sein, um beispielsweise gleichzeitig oder nacheinander jeweilige elektrische Prüfsignale in jeweilige Blitzableiter der Rotorblätter zu leiten. Somit kann die Vorrichtung beispielsweise stärker modularisiert werden, so dass die Vorrichtung für jedes Rotorblatt ein einzelnes Einkopplungs- und Signalgeneratormodul umfassen kann.

Gemäß weiteren Ausführungsbeispielen der vorliegenden Erfindung ist die Energiequelle dazu ausgebildet, um die Mehrzahl von Signalgeneratoren mit Energie zu versorgen. Alternativ weist die Vorrichtung eine, der Mehrzahl von Signalgeneratoren entsprechende, Mehrzahl von Energiequellen auf und eine jeweilige Energiequelle der Mehrzahl von Energiequellen ist dazu ausgebildet, um einen jeweiligen Signalgenerator der Mehrzahl von Signalgeneratoren mit Energie zu versorgen. Somit kann beispielsweise eine einzelne zentrale Energiequelle zur Energieversorgung vorgesehen werden, die dann beispielsweise mit besonders geringem Aufwand ausgetauscht werden kann. Alternativ kann die Vorrichtung stärker modularisiert sein, so dass beispielsweise für jedes Rotorblatt ein Einkopplungsmodul, ein Signalgenerator und eine zugehörige Energiequelle vorhanden sein kann. Ferner kann auch eine weitere zusätzliche Energiequelle zur Versorgung des Kommunikationsmoduls vorhanden sein. Somit kann je nach spezifischer Anwendung die Vorrichtung beispielsweise besonders ausfallssicher gestaltet werden, beispielsweise durch eine stärkere Modularisierung, so dass einzelne Module einfach austauschbar sind oder mit weniger Bauteilen beispielsweise mit einem zentralisierten Signalgenerator und/oder einer zentralisierten Energiequelle.

Weitere Ausführungsbeispiele gemäß der vorliegenden Erfindung umfassen ein System zur Bereitstellung von elektrischen Prüfsignalen, zur Durchführung einer Durchgangsprüfung von elektrischen Leitungen eines Objekts, wobei das Objekt eine Windkraftanlage mit einer Mehrzahl von Rotorblättern ist, wobei die Rotorblätter jeweils elektrische Leitungen in Form von Blitzableitern aufweisen, und wobei das System ferner eine Mehrzahl von Vorrichtungen, gemäß einem oder mehreren der hierin offenbarten Ausführungsbeispiele, umfasst, wobei ein jeweiliges Einkopplungsmodul einer jeweiligen Vorrichtung dazu ausgebildet ist, um ein jeweiliges elektrisches Prüfsignal zur Durchgangsprüfung eines jeweiligen Blitzableiters in ein jeweiliges Rotorblatt einzukoppeln. Einfach ausgedrückt kann also beispielsweise für jedes Rotorblatt eine erfindungsgemäße Vorrichtung vorgesehen sein, um ein entsprechendes Prüfsignal einzukoppeln. Die Vorrichtungen können dabei jeweils beispielsweise mit unterschiedlichen Aktivierungs- und Deaktivierungssignalen angesteuert werden, um die Vorrichtungen beispielsweise iterativ nacheinander zu aktivieren bzw. zu deaktivieren, um einen jeweiligen Blitzableiter eines jeweiligen Rotorblatts zu prüfen. Ferner können die Vorrichtungen jedoch auch auf ein gemeinsames Aktivierungs- und/oder Deaktivierungssignal reagieren, so dass beispielsweise eine Vielzahl von Prüfsignalen gleichzeitig in den Rotorblättern bereitgestellt wird. In einem solchen Fall können beispielsweise Kennungen, die auf ein jeweiliges Prüfsignal aufmoduliert werden, unterschiedlich sein, um die Signale unterscheiden zu können.

Weitere Ausführungsbeispiele gemäß der vorliegenden Erfindung umfassen ein System zur Bereitstellung eines elektrischen Prüfsignals, zur Durchführung einer Durchgangsprüfung einer elektrischen Leitung eines Objekts, umfassend eine Vorrichtung gemäß einem oder mehreren der hierin offenbarten Ausführungsbeispiele, eine Kommunikationseinheit, die dazu ausgebildet ist, um das Aktivierungssignal und das Deaktivierungssignal an das Kommunikationsmodul der Vorrichtung zu übermitteln, und eine Messeinheit, die dazu ausgebildet ist, um das Prüfsignal zu erfassen. Bei der Kommunikationseinheit kann es sich beispielsweise um einen Laptop oder um eine an einer Drohne befestigbare Einheit handeln. Beispielsweise im Fall eines Laptops kann über einen Anschluss in dem Objekt, welcher mit dem Kommunikationsmodul der Vorrichtung verbunden ist, ein Aktivierungssignal bereitgestellt werden. Bei einem Inspektionsflug einer Drohne kann beispielsweise drahtlos mittels einer Kommunikationseinheit, die an der Drohne angebracht ist, das Aktivierungssignal an ein Kommunikationsmodul der Vorrichtung übermittelt werden. Bei der Messeinheit kann es sich beispielsweise um ein Handgerät handeln, das beispielsweise von Technikern oder Kletterern verwendet wird, um das Prüfsignal in der Nähe der Leitung des Objekts zu erfassen. Ferner kann die Messeinheit jedoch auch dazu ausgebildet sein, um beispielsweise an einer Drohne befestigt zu werden, so dass das Prüfsignal bei einem Abfliegen des Objekts erfasst werden kann. Somit kann beispielsweise ein hoher Automatisierungsgrad der Inspektion der Leitung des Objekts erzielt werden.

Gemäß Ausführungsbeispielen der vorliegenden Erfindung ist die Kommunikationseinheit dazu ausgebildet, um an einer Drohne befestigt zu werden. Wie bereits zuvor erläutert, kann somit bei einem händischen, automatischen, autonomen oder beispielsweise auch semi-autonomen (bspw. mit einer Korrektur einer, z.B. vorbestimmten, Flugrichtung oder eines Abstands (bspw. vom Objekt) über z.B. ein zusätzliches Messystem, bspw. Lidar) Flug der Drohne entlang des Objekts, beispielsweise im Zuge einer regelmäßigen Inspektion, die Vorrichtung aktiviert und beispielsweise nach Abschluss der Durchgangsprüfung auch wieder deaktiviert werden. Die Drohne kann beispielsweise vom Boden aus gesteuert oder gestartet werden, so dass es beispielsweise nicht notwendig sein muss, dass sich Menschen insbesondere bei großen Objekten in hohe Höhen oder an schwer zugängliche Orte zur Durchführung einer Inspektion, insbesondere einer Durchgangsprüfung, begeben müssen.

Gemäß weiteren Ausführungsbeispielen der vorliegenden Erfindung ist die Messeinheit dazu ausgebildet, um an einer Drohne befestigt zu werden, und um bei einem Inspektionsflug der Drohne entlang des Objekts das Prüfsignal zu erfassen. Wie bereits zuvor erläutert, kann somit auch bei der Messung menschliches Personal eingespart werden und eine Gefährdung des menschlichen Personals verringert werden. Die Drohne kann somit auch zu für Menschen nicht erreichbaren oder nur schwer erreichbaren Bereichen vordringen, um dort das Prüfsignal zu erfassen und den Zustand des Objekts bzw. die Leitung des Objekts zu bestimmen.

Gemäß weiteren Ausführungsbeispielen der vorliegenden Erfindung ist das Objekt eine Windkraftanlage mit einer Mehrzahl von Rotorblättern, wobei die Rotorblätter jeweils elektrische Leitungen in Form von Blitzableitern aufweisen, und wobei das System ferner eine Mehrzahl von Vorrichtungen gemäß einem oder mehreren der hierin offenbarten Ausführungsbeispiele umfasst, wobei ein jeweiliges Einkopplungsmodul einer jeweiligen Vorrichtung dazu ausgebildet ist, um ein jeweiliges elektrisches Prüfsignal zur Durchgangsprüfung eines jeweiligen Blitzableiters in ein jeweiliges Rotorblatt einzukoppeln. Ferner ist die Kommunikationseinheit dazu ausgebildet, um das Aktivierungssignal und das Deaktivierungssignal an ein jeweiliges Kommunikationsmodul einer jeweiligen Vorrichtung zu übermitteln. Darüber hinaus weist eine Drohne die Messeinheit auf und die Drohne ist dazu ausgebildet, um die Windkraftanlage anzufliegen und um die Mehrzahl von Rotorblättern abzufliegen.

Die Drohne kann dabei insbesondere dazu ausgebildet sein, um die Windkraftanlage autonom anzufliegen und um die Mehrzahl von Rotorblättern autonom abzufliegen. Die Messeinheit kann dabei insbesondere dazu ausgebildet sein, das Prüfsignal beim autonomen Abfliegen der Rotorblätter zu erfassen. Die Erfinder haben erkannt, dass somit ein einfach und effizient automatisierbares System bereitgestellt werden kann, um Blitzableiter von Windkraftanlagen zu prüfen. Durch die Bereitstellung einer erfindungsgemäßen Vorrichtung für einen jeweiligen Blitzableiter bzw. ein jeweiliges Rotorblatt ist das System besonders robust und ermöglicht ebenfalls eine gleichzeitige Prüfung der Mehrzahl von Rotorblättern, beispielsweise unter Einsatz einer korrespondieren Mehrzahl von Drohnen mit einer korrespondierenden Anzahl von Messeinheiten. Hierbei sei wiederum darauf hingewiesen, dass die Drohne ebenfalls händisch, automatisch, oder semi-autonom gesteuert werden kann.

Hierbei sei noch einmal darauf hingewiesen, dass es sich bei der Messeinheit ebenfalls um ein tragbares Gerät handeln kann. Ausführungsbeispiele sind dementsprechend nicht auf die Verwendung von Drohnen eingeschränkt. Beispielsweise kann jedoch auch eine Prüfung mit einer Drohne stattfinden, um beispielsweise einen ungefähren Bereich einer Beschädigung der Blitzschutzleitung zu bestimmen, wobei anschließend Kletterer mit tragbaren Messeinheiten die Windkraftanlage bzw. genauer die Rotorblätter erneut abtasten, um eine entsprechende Beschädigungsstelle wiederzufinden und zu reparieren.

Gemäß weiteren Ausführungsbeispielen der vorliegenden Erfindung umfasst ein erfindungsgemäßes Verfahren ferner ein Übermitteln des Aktivierungssignals mittels einer Kommunikationseinheit an das Kommunikationsmodul, ein Abtasten des Objekts mit einer Messeinheit, ein Erfassen des Prüfsignals beim Abtasten des Objekts und ein Übermitteln des Deaktivierungssignals mittels der Kommunikationseinheit an das Kommunikationsmodul.

Beispielsweise kann eine Grobinformation über eine Beschädigung eines Blitzableiters eines Rotorblattes bekannt sein. Zur Reparatur kann ein Kletterer dann beispielsweise das Rotorblatt erklimmen und das Aktivierungssignal beispielsweise drahtlos mittels einer tragbaren Kommunikationseinheit an das Kommunikationsmodul der Vorrichtung übermitteln. Anschließend kann das Rotorblatt abgeklettert werden und beispielsweise mit einer ebenfalls tragbaren Messeinheit durch den Kletterer das Prüfsignal erfasst werden. Somit kann die Beschädigungsstelle beispielsweise durch eine Abtastung mit sehr geringem Abstand sehr genau bestimmt werden und entsprechend repariert werden. Nach Ende der Erfassung oder der Reparatur kann wiederum das Deaktivierungssignal an das Kommunikationsmodul der Vorrichtung übermittelt werden, um einen beispielsweise austauschbaren Energiespeicher der Vorrichtung zu entlasten und eine lange Lebensdauer zu ermöglichen.

Gemäß weiteren Ausführungsbeispielen der vorliegenden Erfindung umfasst ein erfindungsgemäßes Verfahren ferner ein Anfliegen des Objekts mit einer Drohne, wobei die Drohne eine Messeinheit aufweist, ein Übermitteln des Aktivierungssignals mittels einer Kommunikationseinheit an das Kommunikationsmodul, ein Abfliegen des Objekts mittels der Drohne, ein Erfassen des Prüfsignals beim Abfliegen des Objekts mittels der Messeinheit und ein Übermitteln des Deaktivierungssignals mittels der Kommunikationseinheit an das Kommunikationsmodul. Zum Beispiel, um eine Information für eine anschließende Reparatur bereitzustellen, kann somit beispielsweise händisch, automatisiert, semi-autonom oder autonom mittels der Drohne das Objekt abgeflogen werden. Das Übermitteln des Aktivierungssignals kann dabei beispielsweise beim Anfliegen des Objekts, z. B. bei einem ersten Anfliegen einer Rotornabe mittels der Drohne, übermittelt werden, wobei die Drohne beispielsweise die Kommunikationseinheit aufweisen kann. Ferner kann jedoch auch die Kommunikationseinheit ein Laptop am Boden der Windkraftanlage sein, mit welchem beispielsweise auch die Drohne gesteuert wird. Wie zuvor erwähnt, kann die Übermittlung des Aktivierungssignals dann beispielsweise auch drahtgebunden über eine fest verlegte Leitung in dem Objekt stattfinden. Wie bereits zuvor erwähnt, kann das Anfliegen und Abfliegen des Objekts automatisiert, semi-autonom oder autonom durchgeführt werden, so dass mit geringem Zeit- und Personalaufwand ein Inspektionsergebnis bereitgestellt werden kann (Dabei sei nochmal darauf hingewiesen, dass ein händischer Flug ebenfalls möglich ist). Die Drohne kann dabei ebenfalls das Rotorblatt bzw. allgemein den Leiter des Objekts mit einem sehr geringen Abstand abfliegen, um das Prüfsignal zu erfassen, um anschließend nach dem Erfassen des Prüfsignals das Deaktivierungssignal mittels der Kommunikationseinheit an das Kommunikationsmodul zu übermitteln. Somit kann wiederum Energie eingespart werden, nachdem die Inspektion beendet ist.

Gemäß weiteren Ausführungsbeispielen der vorliegenden Erfindung umfasst ein erfindungsgemäßes Verfahren ferner ein Aktivieren des Kommunikationsmoduls im passiven Betriebsmodus in zeitlichen Abständen für eine vorbestimmte Dauer zum Erhalten des Aktivierungssignals, ein Übermitteln des Aktivierungssignals mittels der Kommunikationseinheit an das Kommunikationsmodul während einer Zeitspanne, die größer ist als ein zeitlicher Abstand zwischen zwei Aktivierungen des Kommunikationsmoduls, ein Erhalten des Aktivierungssignals mittels des Kommunikationsmoduls, um ausgehend von dem passiven Betriebsmodus in den aktiven Betriebsmodus zu wechseln, und ein Übermitteln einer Information über den Betriebszustand mittels des Kommunikationsmoduls an die Kommunikationseinheit.

Gemäß weiteren Ausführungsbeispielen der vorliegenden Erfindung wird für jeden erfassten Wert des Prüfsignals zumindest eines aus einer Zeitinformation, einer absoluten Positionsinformation der Drohne, und/oder einer Abstands- und/oder einer Lageinformation der Drohne bezüglich des Rotorblattes, zusammen mit dem erfassten Wert des Prüfsignals, abgespeichert. Die Erfinder haben erkannt, dass somit eine präzise Lokalisierung einer Beschädigungsstelle ermöglicht werden kann.

Gemäß weiteren Ausführungsbeispielen der vorliegenden Erfindung umfasst ein erfindungsgemäßes Verfahren ferner ein Vergleichen des erfassten Prüfsignals mit einem Referenzsignal, wobei das Referenzsignal ein berechneter Signalverlauf eines erfassten Prüfsignals über der elektrischen Leitung und/oder ein, bei einer vorherigen Messung gemessener, Signalverlauf des erfassten Prüfsignals über der elektrischen Leitung ist, um eine Information über eine Beschädigung der elektrischen Leitung zu bestimmen.

Bei dem berechneten Signalverlauf kann es sich beispielsweise um das Ergebnis einer Simulation, z. B. basierend auf CAD-Daten, handeln. Somit kann beispielsweise auch bei einem Erstflug an einer neu aufgebauten Anlage überprüft werden, ob der Leiter bzw. die Leitung intakt ist und/oder korrekt montiert wurde. Ferner haben die Erfinder jedoch auch erkannt, dass beispielsweise aufgrund unterschiedlicher Umwelteinflüsse und lokaler Gegebenheiten am Ort des Objekts die Leitung bzw. der Leiter in dem Objekt sich auf unterschiedliche Arten und Weisen verändern kann, so dass zur Beurteilung des Zustands oder der Zustandsveränderung ein vorheriges Messergebnis herangezogen werden kann.

Gemäß weiteren Ausführungsbeispielen der vorliegenden Erfindung ist bei einem erfindungsgemäßen Verfahren das Objekt eine Windkraftanlage mit einer Rotornabe und einer Mehrzahl von, an der Rotornabe angeordneten, Rotorblättern, wobei die Rotorblätter jeweils elektrische Leitungen in Form von Blitzableitern aufweisen. Ferner sind Vorrichtungen einer Mehrzahl von Vorrichtungen gemäß einem oder mehreren der hierin offenbarten Ausführungsbeispiele jeweils mit einem Blitzableiter eines jeweiligen Rotorblattes gekoppelt. Dabei umfasst das erfindungsgemäße Verfahren ferner ein Anfliegen der Windkraftanlage, bspw. der Rotornabe oder einer Rotorblattspitze, mittels einer Drohne, wobei sich die Vorrichtungen beim Anflug der Drohne jeweils im passiven Betriebsmodus befinden. Darüber hinaus umfasst das Verfahren ein Übermitteln eines Aktivierungssignals mittels einer Kommunikationseinheit der Drohne an ein Kommunikationsmodul einer der Vorrichtungen, um die eine Vorrichtung in den aktiven Betriebsmodus zu versetzen. Außerdem umfasst das Verfahren ein Einkoppeln eines vom Signalgenerator der einen Vorrichtung erzeugten Prüfsignals in den Blitzableiter des mit der einen Vorrichtung gekoppelten Rotorblattes, mittels des Einkopplungsmoduls der einen Vorrichtung. Darüber hinaus umfasst das Verfahren ein Abfliegen des, mit der einen Vorrichtung gekoppelten, Rotorblattes mit der Drohne, während das Prüfsignal in den Blitzableiter des Rotorblattes eingekoppelt wird, ein Erfassen des Prüfsignals mittels einer Messeinheit der Drohne während des Abfliegens des Rotorblattes. Optional kann das Verfahren bspw. ein erneutes Anfliegen der Rotornabe oder der Rotorblattspitze umfassen.

Ferner umfasst das Verfahren ein Übermitteln eines Deaktivierungssignals, mittels der Kommunikationseinheit der Drohne, an das Kommunikationsmodul der einen Vorrichtung, um die eine Vorrichtung zurück in den passiven Betriebsmodus zu versetzen. Außerdem umfasst das Verfahren ein iteratives Wiederholen der Schritte, Übermitteln eines Aktivierungssignals, Einkoppeln eines Prüfungssignals, Abfliegen des Rotorblattes, Erfassen des Prüfsignals, (optional erneutes Anfliegen der Rotornabe oder der Rotorblattspitze) und Übermitteln eines Deaktivierungssignals für die weiteren Vorrichtungen und die weiteren, mit den Vorrichtungen gekoppelten, Rotorblätter der Mehrzahl von Vorrichtungen.

In einfachen Worten kann die Drohne die Windkraftanlage, also beispielsweise die Flügelnabe oder eine Rotorblattspitze anfliegen. Der Drohnenflug kann dabei beispielsweise händisch, automatisiert, semi-autonom oder autonom erfolgen. Die Drohne kann anschließend ein Funksignal initiieren, um eine der Vorrichtungen in den aktiven Betriebsmodus zu versetzen oder, einfach ausgedrückt, um diese zu wecken. Dabei kann die Drohne beispielsweise eine bestimmte Zeitdauer, z. B. 75 Sekunden lang, warten und das Aktivierungssignal bereitstellen, um sicherzugehen, dass im passiven Betriebsmodus der einen Vorrichtung ein Weckintervall des Kommunikationsmoduls getroffen wird oder einfach ausgedrückt erwischt wird, um das Aktivierungssignal zu übermitteln und die Vorrichtung zu aktivieren. Optional kann zusätzlich mittels des Kommunikationsmoduls Feedback von der Vorrichtung über den aktiven Betriebsmodus nach Aktivierung der Vorrichtung an die Kommunikationseinheit der Drohne zurückübermittelt werden. Anschließend kann die Drohne also den Flügel bzw. das Rotorblatt, bspw. händisch, automatisiert, semi-autonom oder autonom, abfliegen, dabei das Prüfsignal erfassen, optional an die Nabe zurückkehren, und die Vorrichtung anschließend wieder in den passiven Betriebsmodus, also beispielsweise einen Sleep Mode, zurückversetzen. Dieses Vorgehen kann iterativ, also beispielsweise nacheinander, mit der einen Drohne wiederholt werden, um die weiteren Vorrichtungen zu aktivieren und die weiteren Rotorblätter zu inspizieren.

Dabei sei darauf hingewiesen, dass Ausführungsbeispiele gemäß der vorliegenden Erfindung nicht bezüglich einer speziellen Flugroutenführung limitiert sind.

So kann eine erfindungsgemäße Vorrichtung von einer Kommunikationseinheit einer Drohne von der Nabe aus aktiviert werden wie oben erwähnt, jedoch kann eine Aktivierung auch während eines Anflugs der Drohne zu der Nabe, oder eines Anflugs der Drohne zu einer Rotorblattspitze oder von einer Rotorblattspitze aus erfolgen.

Entsprechend kann auch eine Erfassung des Prüfsignals von einer Vielzahl möglicher Startpunkte aus, und mit einer Vielzahl möglicher Endpunkte der Flugtrajektorie durchgeführt werden. So kann bspw. ein Rotorblatt ausgehend von einer Rotorblattspitze aus abgeflogen werden, um das Prüfsignal zu erfassen. Umgekehrt kann ein Prüfflug auch ausgehend von der Nabe oder dem Rotorblattflansch gestartet werden.

Beispielsweise kann ausgehend von der Nabe der Windkraftanlage eine Vorrichtung zur Induktion des Prüfsignals aktiviert werden und das zugehörige Rotorblatt anschließend abgeflogen werden. Ausgehend von der Rotorblattspitze kann die Vorrichtung bspw. wieder ausgeschaltet werden mittels des Deaktivierungssignals, und die Drohne kann bspw. in einem Wartemodus zu einer weiteren Rotorblattspitze fliegen. Auf dem Weg zu der weiteren Spitze kann bspw. eine zum Rotorblatt zugehörige Vorrichtung aktiviert werden, um bei diesem Prüfflug ausgehend von der Rotorblattspitze zur Nabe hin das Prüfsignal im Blitzableiter des Rotorblattes aufzunehmen.

Dementsprechend sei darauf hingewiesen, dass Ausführungsbeispiele gemäß der vorliegenden Erfindung eine Vielzahl von Flugrouten oder Flugmuster und entsprechend auch Vorgehensweisen zur Aktivierung und Deaktivierung von erfindungsgemäßen Vorrichtungen umfassen.

### Figurenkurzbeschreibung

Beispiele gemäß der vorliegenden Offenbarung werden nachfolgend bezugnehmend auf die beiliegenden Figuren näher erläutert. Hinsichtlich der dargestellten schematischen Figuren wird darauf hingewiesen, dass die dargestellten Funktionsblöcke sowohl als Elemente oder Merkmale der offenbarungsgemäßen Vorrichtung als auch als entsprechende Verfahrensschritte des offenbarungsgemäßen Verfahrens zu verstehen sind, und auch entsprechende Verfahrensschritte des offenbarungsgemäßen Verfahrens davon abgeleitet werden können. Es zeigen:
- Fig. 1: eine schematische Ansicht einer Vorrichtung zur Bereitstellung eines elektrischen Prüfsignals gemäß Ausführungsbeispielen der vorliegenden Erfindung;
- Fig. 2: eine schematische Ansicht einer Vorrichtung mit einer optionalen Schutzdiode gemäß Ausführungsbeispielen der vorliegenden Erfindung;
- Fig. 3: eine schematische Seitenansicht einer Windkraftanlage mit einer erfindungsgemäßen Vorrichtung gemäß Ausführungsbeispielen der vorliegenden Erfindung;
- Fig.: 3aeine schematische Seitenansicht einer Windkraftanlage mit erfindungsgemäßen Vorrichtungen gemäß Ausführungsbeispielen der vorliegenden Erfindung;
- Fig. 4: ein System zur Bereitstellung von elektrischen Prüfsignalen gemäß Ausführungsbeispielen der vorliegenden Erfindung;
- Fig. 5: ein weiteres System zur Bereitstellung eines elektrischen Prüfsignals mit weiteren optionalen Merkmalen gemäß Ausführungsbeispielen der vorliegenden Erfindung;
- Fig. 6: ein schematisches Blockschaltbild von Elektronik einer Vorrichtung gemäß Ausführungsbeispielen der vorliegenden Erfindung; und
- Fig. 7: ein schematisches Blockdiagramm eines Verfahrens gemäß Ausführungsbeispielen der vorliegenden Erfindung.

### Detaillierte Beschreibung der Beispiele gemäß den Figuren

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen oder ähnlichen Bezugszeichen versehen sind, so dass die in unterschiedlichen Ausführungsbeispielen dargestellte Beschreibung dieser Elemente untereinander austauschbar ist bzw. aufeinander angewendet werden kann.

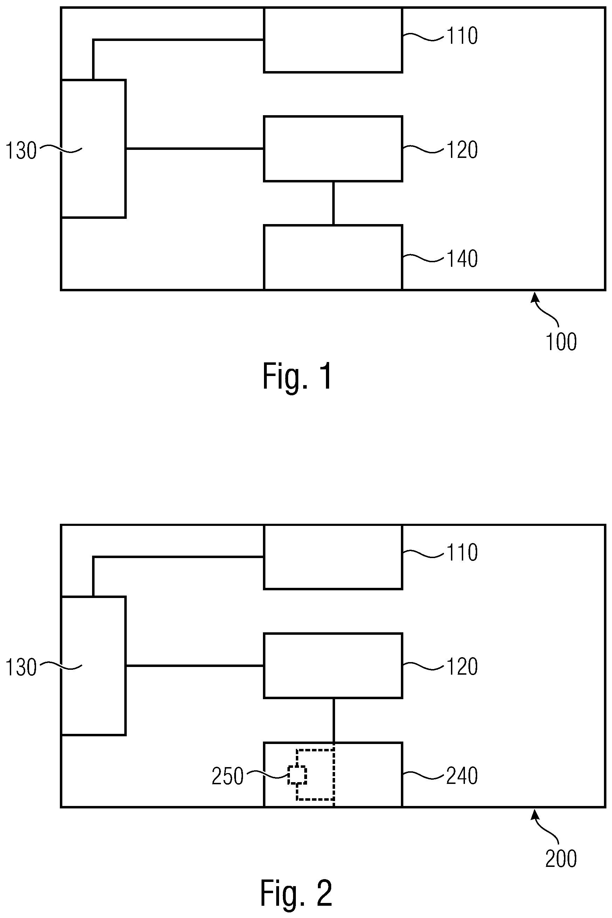

Fig. 1 zeigt eine schematische Ansicht einer Vorrichtung zur Bereitstellung eines elektrischen Prüfsignals gemäß Ausführungsbeispielen der vorliegenden Erfindung. Fig. 1 zeigt die Vorrichtung 100 zur Bereitstellung eines elektrischen Prüfsignals, zur Durchführung einer Durchgangsprüfung einer elektrischen Leitung eines Objekts. Die Vorrichtung 100 umfasst ein Kommunikationsmodul 110, das dazu ausgebildet ist, um ein Aktivierungssignal zu erhalten, um die Vorrichtung von einem passiven Betriebsmodus in einen aktiven Betriebsmodus zu versetzen und um ein Deaktivierungssignal zu erhalten, um die Vorrichtung von dem aktiven Betriebsmodus in den passiven Betriebsmodus zu versetzen. Ferner umfasst die Vorrichtung 100 einen Signalgenerator 120, der dazu ausgebildet ist, um im aktiven Betriebsmodus das elektrische Prüfsignal zu erzeugen. Außerdem umfasst die Vorrichtung 100 eine Energiequelle 130, die ausgebildet ist, um das Kommunikationsmodul und den Signalgenerator mit Energie zu versorgen. Darüber hinaus umfasst die Vorrichtung 100 ein Einkopplungsmodul 140, das ausgebildet ist, um im aktiven Betriebsmodus das elektrische Prüfsignal in die elektrische Leitung des Objekts einzukoppeln.

Ein erfindungsgemäßes Verfahren kann anhand Fig. 1 also bspw. wie folgt zusammengefasst werden:
Versorgen eines Kommunikationsmoduls 110 mit Energie einer Energiequelle 130 und Erhalten eines Aktivierungssignals mittels des Kommunikationsmoduls 110, um ausgehend von einem passiven Betriebsmodus in einen aktiven Betriebsmodus zu wechseln und Versorgen eines Signalgenerators 120 im aktiven Betriebsmodus mit Energie der Energiequelle 130 und Erzeugen eines elektrischen Prüfsignals im aktiven Betriebsmodus mittels des Signalgenerators 120 und Einkoppeln des elektrischen Prüfsignals im aktiven Betriebsmodus in die elektrische Leitung des Objekts und Erhalten eines Deaktivierungssignals mittels des Kommunikationsmoduls 110, um vom aktiven Betriebsmodus in den passiven Betriebsmodus zu wechseln.

Das Kommunikationsmodul 110 kann dabei optional dazu ausgebildet sein, um das Aktivierungssignal oder das Deaktivierungssignal drahtlos zu erhalten. Dementsprechend kann es sich bei dem Kommunikationsmodul beispielsweise um ein Funkmodul handeln. Die Kommunikation kann dabei beispielsweise über eine beliebige Funkbandbreite erfolgen, beispielsweise über WLAN- oder Mobilfunkfrequenzen. Das Kommunikationsmodul kann dabei insbesondere dazu ausgebildet sein, um ein gesichertes oder verschlüsseltes Aktivierungs- und/oder Deaktivierungssignal zu erhalten, um eine Aktivierung der Vorrichtung durch Dritte zu unterbinden. Die Vorrichtung kann dabei insbesondere eine Antenne oder beispielsweise eine ähnliche Einheit zur Verbesserung der Abstrahl- und/oder Empfangscharakteristik umfassen.

Wie bereits zuvor erläutert, ermöglicht eine entsprechende Drahtloskommunikation eine Bedienung der Vorrichtung beispielsweise unabhängig von einem spezifischen Standort der Vorrichtung an oder in dem Objekt. Die Erfinder haben erkannt, dass dies insbesondere bei großen Objekten und/oder bei Objekten, bei denen Leitungen in schwer zugänglichen Bereichen inspiziert werden müssen, große Vorteile aufweisen kann. So kann beispielsweise Personal eingespart werden, da kein zusätzlicher Techniker notwendig ist, der vor Ort die Vorrichtung bedient, also beispielsweise die Vorrichtung zum Erzeugen des Prüfsignals aktiviert und diese dementsprechend danach deaktiviert. Insbesondere kann beispielsweise mit einer autonom agierenden Vorrichtung, wie beispielsweise einer autonom oder automatisch fliegenden Drohne, die Durchgangsprüfung durchgeführt werden, wobei durch eine Kommunikationseinheit der Drohne eine drahtlose Kommunikation mit dem Kommunikationsmodul hergestellt werden kann. Somit kann beispielsweise eine entsprechende Durchgangsprüfung voll automatisiert oder voll autonom durchgeführt werden.

Alternativ kann das Kommunikationsmodul 110 beispielsweise jedoch auch dazu ausgebildet sein, um das Aktivierungssignal und/oder das Deaktivierungssignal drahtgebunden zu erhalten.

Ganz allgemein kann die Vorrichtung zur Bereitstellung des elektrischen Prüfsignals gemäß Ausführungsbeispielen fest mit dem Objekt verbunden sein oder auch nur im Zuge einer Inspektion an dem Objekt bzw. genauer der elektrischen Leitung des Objekts befestigt werden. Beispielsweise für den Fall einer festen baulichen Verbindung mit dem Objekt kann so innerhalb des Objekts beispielsweise eine Kommunikationsleitung vorgesehen sein, so dass von einer festgelegten, beispielsweise gut erreichbaren Position des Objekts aus die Vorrichtung angesteuert werden kann. Somit kann eine beispielsweise besonders störungssichere und robuste Kommunikation gewährleistet werden.

Optional kann es sich bei der Energiequelle 130 um einen Energiespeicher handeln. Der Energiespeicher kann dabei austauschbar sein und/oder wiederaufladbar sein. Die Erfinder haben erkannt, dass ein solcher Energiespeicher insbesondere bei Vorrichtungen, die langfristig mit dem Objekt verbunden werden, also beispielsweise in dem Objekt verbaut sind, Vorteile aufweisen. So kann die Vorrichtung beispielweise aus der Ferne mit dem Kommunikationsmodul drahtlos oder drahtgebunden aktiviert und deaktiviert werden, um Inspektionen durchzuführen, ohne dass ein Techniker zur Vorrichtung selbst gelangen muss, um einen Energieversorgung herzustellen. Die Energiequelle in Form des Energiespeichers kann dann beispielsweise in bestimmten Zeitabständen ausgetauscht oder wiederaufgeladen werden. Entsprechend kann ein solcher Energiespeicher also so dimensioniert sein, dass eine Vielzahl von Durchgangsprüfungen durchgeführt werden kann, bevor ein Austausch oder ein Wiederaufladen notwendig sein muss. Beispielsweise kann es sich bei dem Energiespeicher um einen Akkumulator oder eine Batterie, beispielsweise eine Lithiumbatterie, handeln. Bei besonders bevorzugten Ausführungsbeispielen kann die Batterie beispielsweise durch einen Techniker mit einem einfachen Handgriff ausgetauscht werden. Eine entsprechende Batterie kann beispielsweise einer Kapazität von zumindest 5000 mAh und höchstens 12000 mAh beispielsweise bei einer Spannung zwischen zumindest 10 V und höchstens 14 V aufweist. Beispielsweise kann die Batterie eine Kapazität von 8000 mAh mit einer Toleranz von +/-10 % bei 12 V mit einer Toleranz von +/-10 % aufweisen.

Alternativ kann die Energiequelle 130 jedoch auch dazu ausgebildet sein, um mit einer externen Leistungsversorgung gekoppelt zu werden. Beispielsweise bei Objekten, die zur Energieerzeugung dienen, oder die zur Energie- oder Leistungsaufnahme ausgebildet sind, die bspw. konstant mit Energie versorgt werden, kann beispielsweise auf vorhandene Leistungselektronik zurückgegriffen werden, um die Vorrichtung mit Energie zu versorgen. Die Energiequelle kann dabei dazu ausgebildet sein, um bei jeder Inspektion an die externe Leistungsversorgung angekoppelt und zu entkoppelt werden, oder kann dazu ausgebildet sein, um permanent mit einer entsprechenden Leistungsversorgung verbunden zu sein, beispielsweise für den Fall, dass die Vorrichtung in das Objekt integriert ist.

Optional kann das Einkopplungsmodul 140 dazu ausgebildet sein, um im aktiven Betriebsmodus das elektrische Prüfsignal induktiv und/oder kapazitiv in die elektrische Leitung des Objekts einzukoppeln. Die Erfinder haben erkannt, dass dies eine besonders effiziente Nachrüstung von existierenden Objekten zur Bereitstellung der Funktionalität einer Durchgangsprüfung einer Leitung oder eines Leiters in dem Objekt ermöglicht. Somit müssen beispielsweise keine elektrischen Leitungen des Objekts freigelegt werden, um das Prüfsignal in diese einzukoppeln. Ferner kann somit auch beispielsweise eine galvanische Entkopplung zwischen der Vorrichtung bzw. dem Einkopplungsmodul und der elektrischen Leitung bereitgestellt werden. Somit kann die Vorrichtung beispielsweise von Spannungsspitzen und/oder Stromspitzen auf der elektrischen Leitung im Wesentlichen geschützt sein. Ferner weist eine derartige Einkopplung Vorteile im Hinblick auf zueinander relativ bewegliche Bauteile auf. Wenn das Objekt, wie beispielsweise ein Windrad, dazu ausgebildet ist, sich zu bewegen, kann es Vorteil aufweisen, wenn das Einkopplungsmodul nicht fest mit einer elektrischen Leitung des Objekts verbunden ist, sondern eine solche Verbindung induktiv vorhanden sein kann.

Alternativ kann das Einkopplungsmodul 140 jedoch auch dazu ausgebildet sein, das Prüfsignal im aktiven Betriebsmodus mittels einer schaltbaren ohmschen Verbindung in die Leitung des Objekts einzukoppeln. Somit kann das Einkopplungsmodul beispielsweise permanent mit der Leitung verbunden sein, wobei die elektrische Leitfähigkeit beispielsweise mittels eines Schalters hergestellt oder getrennt werden kann. Somit kann die Vorrichtung beispielsweise wiederum von der Leitung entkoppelt werden, beispielsweise, um einen Regelbetrieb zu ermöglichen oder auch, um die Vorrichtung beispielsweise vor Blitzeinschlägen zu schützen, insbesondere bei beispielsweise besonders großen Objekten, die auf Blitze anziehend wirken können, zu ermöglichen.

Als weiteres optionales Merkmal kann das Kommunikationsmodul 110 dazu ausgebildet sein, im passiven Betriebsmodus in zeitlichen Abständen für eine vorbestimmte Dauer zum Erhalten des Aktivierungssignals aktiviert zu werden. Dabei kann im passiven Betriebsmodus ein Energieverbrauch der Vorrichtung geringer sein als im aktiven Betriebsmodus. Beispielsweise kann die Vorrichtung im passiven Betriebsmodus in einfachen Worten ausgeschaltet sein, um lediglich zyklisch das Kommunikationsmodul zu aktivieren, um ein Übertragen eines Aktivierungssignals zu ermöglichen. Basierend auf dem Aktivierungssignal kann dann entsprechend die Vorrichtung eingeschaltet werden, um das Prüfsignal zu erzeugen und einzukoppeln. Somit kann beispielsweise insbesondere mit einem Energiespeicher eine langfristige Energieversorgung gewährleistet werden, so dass Austausch- oder Wiederaufladeintervalle für den Energiespeicher als große zeitliche Intervalle gesetzt werden können.

Beispielsweise, wenn es sich bei der Energiequelle um einen Energiespeicher handelt, kann das Kommunikationsmodul 110 ferner dazu ausgebildet sein, um im aktiven Betriebsmodus einen Ladezustand des Energiespeichers zu übermitteln. Optional kann die Vorrichtung jedoch ferner dazu ausgebildet sein, eine Selbstdiagnose durchzuführen und mittels des Kommunikationsmoduls auch weitere Informationen über die Vorrichtung bereitzustellen. In beiden Fällen kann somit die Robustheit der Vorrichtung verbessert werden, da beispielsweise abgeschätzt werden kann, ob eine verbleibende Energiemenge im Energiespeicher dazu ausreicht, eine Inspektion durchzuführen oder auch um beispielsweise eine Wartung oder einen Austausch der Vorrichtung zu planen. Ferner kann entsprechend ein Aufladen oder ein Austausch des Energiespeichers geplant werden.

Als weiteres optionales Merkmal kann das Kommunikationsmodul 110 ferner dazu ausgebildet sein, um eine Information über den Betriebszustand der Vorrichtung zu übermitteln. Insbesondere kann das Kommunikationsmodul 110 dazu ausgebildet sein, um einen Wechsel vom passiven in den aktiven Betriebszustand anzuzeigen. Somit kann beispielsweise rückgemeldet werden, dass ein Aktivierungssignal erfolgreich übertragen wurde. Außerdem kann somit übermittelt werden, dass die Vorrichtung bereit ist, um eine Durchgangsprüfung eines Leiters eines Objekts durchzuführen oder in anderen Worten das Prüfsignal bereitzustellen oder gar, dass das Prüfsignal bereits bereitgestellt wird. Die Erfinder haben erkannt, dass dies insbesondere bei Objekten, bei denen die Leiter schwer zugänglich oder schwer erreichbar sind, große Vorteile aufweisen kann, da es ansonsten beispielsweise dazu kommen kann, dass ein Kletterer oder eine Drohne in Position ist, um das Prüfsignal zu erfassen, ohne Gewissheit darüber zu haben, dass die Vorrichtung zur Erzeugung des Prüfsignal überhaupt bereit dazu ist, oder beispielsweise ein Fehler vorliegt.

Als weiteres optionales Merkmal kann der Signalgenerator 120 dazu ausgebildet sein, ein Funkfrequenzsignal und/oder ein Hochfrequenzsignal und/oder ein getaktetes Niederfrequenzsignal als Prüfsignal zu erzeugen. Die Erfinder haben erkannt, dass bspw. mittels eines Hochfrequenzsignals besonders effizient ein elektromagnetisches Feld um den Leiter herum erzeugt werden kann, welcher mit einer Messeinheit erfassbar ist. Somit kann auch aus größeren Abständen um den Leiter des Objekts herum das Prüfsignal erfasst werden, um Rückschlüsse auf den Leiter bzw. die Leitung zu ziehen. Ferner kann mittels des Hochfrequenzsignals eine induktive oder auch kapazitive Einkopplung in die Leitung des Objekts bereitgestellt werden. Außerdem können beispielsweise auch kleinere Leiterunterbrechungen überbrückt werden, die vielleicht für einen Blitzeinschlag keine Relevanz aufweisen und dementsprechend bei einer Durchgangsprüfung des Leiters, beispielsweise Blitzableiters, auch nicht als Defekte erkannt werden sollen.

Als weiteres optionales Merkmal kann der Signalgenerator 120 dazu ausgebildet sein, um eine Impedanzanpassung an die elektrische Leitung des Objekts zu ermöglichen. In anderen Worten kann der Generatorausgang beispielsweise innerhalb gewisser Grenzen eine Impedanzanpassung (Abstrahlung) vornehmen, das heißt, es kann versucht werden, einen optimalen Wert abhängig von der Leitung bzw. dem Leiter zu erzielen, bspw. abhängig von einer Länge der Leitung oder des Leiters, oder auch abhängig von einer Art der Leitung oder des Leiters. Dabei sei darauf hingewiesen, dass nicht zwingend eine gleichmäßig reproduzierbare Feldstärke für alle möglichen Variationen von elektrischen Leitern, beispielsweise Blitzableitern oder Blitzschutzsystemen, erreicht werden muss. Mittels der Impedanzanpassung kann also beispielsweise eine Effizienz der Signaleinspeisung verbessert werden, beispielsweise um Signalreflektion und Verluste zu minimieren. Somit kann ebenfalls ein Austauschintervall oder ein Wiederaufladeintervall eines Energiespeichers verlängert werden, indem Energie bei der Einspeisung und bei der Signalübertragung eingespart werden kann.

Als weiteres optionales Merkmal kann die Vorrichtung dazu ausgebildet sein, um dem Prüfsignal eine Signalkennung auf zu modulieren. Damit kann das Prüfsignal beispielsweise einfach von anderen Signalen unterschieden werden, so dass eine robuste und genaue Auswertung der Durchgangsprüfung ermöglicht werden kann. Ferner ermöglicht die Verwendung einer Signalkennung auch die parallele Einspeisung einer Vielzahl von Prüfsignalen, beispielsweise in unterschiedliche Leiter, so dass die Signale noch auseinandergehalten werden können. Somit kann beispielsweise besonders zeiteffizient die Inspektion eines Objekts mit vielen Leitern, die zu prüfen sind, durchgeführt werden.

Fig. 2 zeigt eine schematische Ansicht einer Vorrichtung mit einer optionalen Schutzdiode gemäß Ausführungsbeispielen der vorliegenden Erfindung. Fig. 2 zeigt die Vorrichtung 200 umfassend, neben den Elementen, die bereits im Kontext mit Fig. 1 erläutert wurden, einem Kommunikationsmodul 240. Als weiteres optionales Merkmal umfasst die Vorrichtung 200 eine Schutzdiode 250, die dazu ausgebildet ist, um die Vorrichtung 200 vor einer Spannungs- und/oder Stromspitze auf der elektrischen Leitung des Objekts zu schützen. Als optionales Merkmal handelt es sich bei der Schutzdiode 250 um eine Suppressordiode, die parallel zum Einkopplungsmodul 240 verschaltet ist. Wie in Fig. 2 angedeutet, kann die Suppressordiode beispielsweise parallel zu einem Signalpfad des Einkopplungsmoduls verschaltet sein oder kann optional aber auch beispielsweise ein außerhalb des Einkopplungsmoduls extern angeordnetes Element sein. Ganz allgemein kann die Schutzdiode auch an oder zwischen anderen Elementen der Vorrichtung angeordnet sein. Bei der Schutzdiode kann es sich beispielsweise insbesondere um eine Transildiode handeln. Eine solche Diode braucht beispielsweise keine Ableitung gegen Masse, sondern wird intern parallel zum Einkopplungsmodul, beispielsweise einer Induktionsspule, angebracht und kann so Überspannungsimpulse abfangen. Beispielsweise kann so ein Blitzeinschlag abgefangen werden, so dass die Vorrichtung nicht zerstört wird.

Beispielsweise kann eine entsprechende Schutzdiode z. B. in Form der Suppressordiode, leitend werden, wenn eine spezifische Spannungsschwelle überschritten wird. Eine entsprechende Stromspitze wird dann parallel an dem zu schützenden Bauteil, also beispielsweise bei dem Einkopplungsmodul, vorbeigeführt. Die Diode kann dabei die Energie intern absorbieren. Ferner kann eine entsprechende Diode als unidirektionale oder bidirektionale Diode ausgeführt sein.

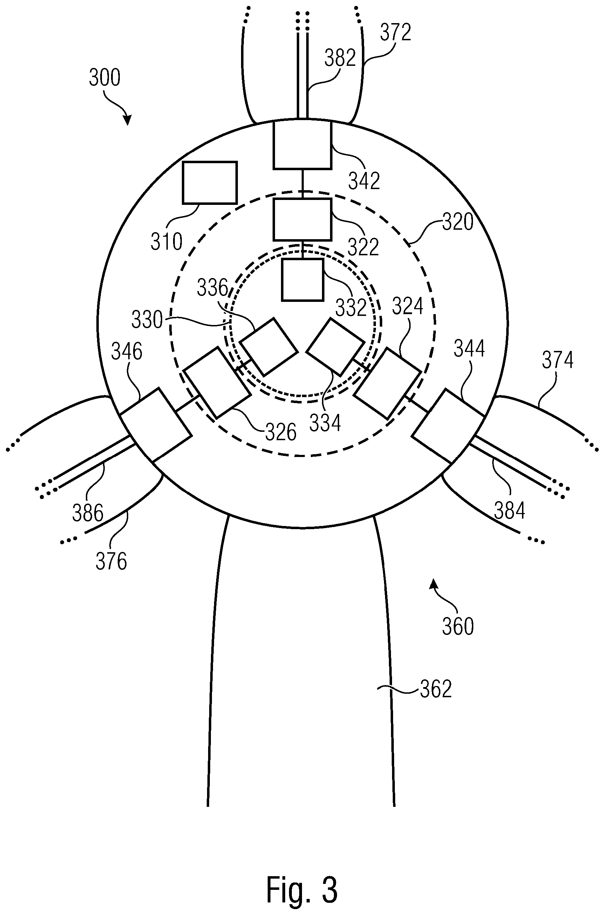

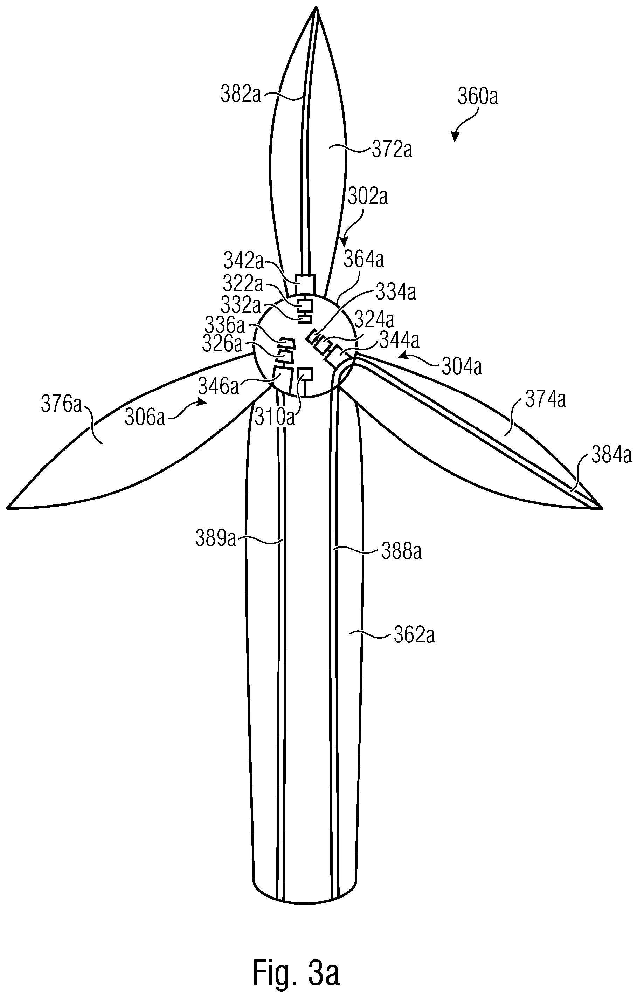

Fig. 3 zeigt eine schematische Seitenansicht einer Windkraftanlage mit einer erfindungsgemäßen Vorrichtung gemäß Ausführungsbeispielen der vorliegenden Erfindung. Fig. 3 zeigt eine Windkraftanlage 360 mit einem Turm 362, einer Gondel 364 und einer Mehrzahl von Rotorblättern 372, 374, 376, wobei die Rotorblätter jeweils elektrische Leitungen 382, 384, 386 in Form von Blitzableitern aufweisen. Ganz allgemein, sei im Kontext von Fig. 3 darauf hingewiesen, dass somit ein Objekt eine Windkraftanlage 360 oder ein Rotorblatt einer solchen sein kann, wobei eine erfindungsgemäße Vorrichtung dazu ausgebildet ist elektrische Leitungen zu prüfen.

Ferner zeigt Fig. 3 die Vorrichtung 300 umfassend ein Kommunikationsmodul 310, sowie wie als optionales Merkmal dargestellt, eine Mehrzahl von, der Mehrzahl von Rotorblättern entsprechenden, Einkopplungsmodulen 342, 344, 346. Dabei sei jedoch darauf hingewiesen, dass Vorrichtungen gemäß der vorliegenden Erfindung auch lediglich ein einzelnes Einkopplungsmodul aufweisen können. Die jeweiligen Einkopplungsmodule 342, 344, 346 sind jeweils dazu ausgebildet, um das elektrische Prüfsignal zur Durchgangsprüfung eines jeweiligen Blitzableiters 382, 384, 386 in ein jeweiliges Rotorblatt 372, 374, 376 einzukoppeln. Optional können das eine oder die mehreren Einkopplungsmodule 342, 344, 346 an einem Blitzableiter eines Rotorblattes, an einer Zuleitung zum Rotorblatt oder im Rotorblatt integriert angeordnet sein. Beispielsweise beim Neubau einer Anlage kann so eine erfindungsgemäße Vorrichtung bereits in das Objekt oder genauer das Rotorblatt integriert werden. Im integrierten Zustand kann das Einkopplungsmodul jedoch neben einer ohmschen, beispielsweise mit Schalter, auch dazu ausgebildet sein, induktiv oder kapazitiv das Prüfsignal in den Blitzableiter zu induzieren oder, allgemein ausgedrückt, einzukoppeln.

Als weiteres optionales Merkmal umfasst die Vorrichtung 300 einer der Mehrzahl von Einkopplungsmodulen 342, 344, 346, entsprechenden Mehrzahl von Signalgeneratoren 322, 324, 326, wobei ein jeweiliger Signalgenerator dazu ausgebildet ist, um im aktiven Betriebsmodus der Vorrichtung 300 das jeweilige elektrische Prüfsignal zur Einkopplung in einen jeweiligen Blitzableiter zu erzeugen. Dabei sei jedoch darauf hingewiesen, dass das Vorhandensein einer Mehrzahl von Signalgeneratoren lediglich optional ist. Beispielsweise kann auch lediglich ein einzelner Signalgenerator 320 mit mehreren Signalausgängen vorhanden sein.

Analog kann als weiteres optionales Merkmal eine einzelne Energiequelle 330 oder einer der Mehrzahl von Signalgeneratoren 322, 324, 326 entsprechende Mehrzahl von Energiequellen 332, 334, 336 dazu ausgebildet sein, um einen jeweiligen Signalgenerator mit Energie zu versorgen.

Jeweils sei wiederum darauf hingewiesen, dass eine Windkraftanlage als Objekt wiederum lediglich als Beispiel dient. So können beispielsweise auch Funkmasten, ein Turm einer Windkraftanlage, große Antennen, Schiffe, beispielsweise große Containerschiffe, Hafenanlagen oder allgemein andere Großgebilde elektrische Leitungen aufweisen, die beispielsweise schwer zugänglich sind und die aber dennoch geprüft werden müssen.

Fig. 3a zeigt eine schematische Seitenansicht einer Windkraftanlage mit erfindungsgemäßen Vorrichtungen gemäß Ausführungsbeispielen der vorliegenden Erfindung. Fig. 3a zeigt eine Windkraftanlage 360a mit einem Turm 362a, einer Gondel 364a und einer Mehrzahl von Rotorblättern 372a, 374a, 376a, wobei die Rotorblätter jeweils elektrische Leitungen 382a, 384a (Im Sinne der Übersichtlichkeit Blitzableiter in Rotorblatt 376a nicht gezeigt) in Form von Blitzableitern aufweisen. Ferner umfasst der Turm 362a einen Leiter 388a, der mit dem Blitzableiter 384a verbunden ist, sowie einen zweiten Leiter 389a.

Ferner zeigt Fig. 3 eine Mehrzahl von Vorrichtungen 302a, 304a, 306a umfassend jeweils ein Einkopplungsmodul 342a, 344a, 346a, jeweils ein Signalgenerator 322a, 324a, 326a, sowie eine jeweils Energiequelle 332a, 334a, 336a. Im Sinne der Übersichtlichkeit sind jeweilige Kommunikationsmodule nicht gezeigt.

Wie als optionales Merkmal in Fig. 3a gezeigt, kann ein erfindungsgemäßes Einkopplungsmodul 342a bspw. in ein Rotorblatt 372a, also bspw. einen Flügel integriert werden.

Ferner kann ein Turm 362a einen oder mehrere Leiter aufweisen. Somit kann eine Vorrichtung 306a, bspw. dazu ausgebildet sein, um eine Durchgangsprüfung des Leiters 389a bereitzustellen.

Ein entsprechender Leiter im Turm, bspw. Leiter 388a, kann bspw. dazu ausgebildet sein eine Überspannung, z.B. aufgrund eines Blitzeinschlages, von einem oder mehreren Blitzableitern in den Rotorblättern abzuleiten. Somit kann eine Vorrichtung 304a bspw. nicht nur eine Durchgangsprüfung des Blitzableiters 384a durchzuführen sondern zugleich auch den mit dem Blitzableiter 384a verbundenen Leiter 388a prüfen.

Im Sinne der Vollständigkeit sei darauf hingewiesen, dass ein jeweiliger Signalgenerator 322a, 324a, 326a jeweils dazu ausgebildet ist, um im aktiven Betriebsmodus der jeweiligen Vorrichtung das elektrische Prüfsignal, zur Einkopplung mittels einem jeweiligen Einkoppsmodul 342a, 344a, 362a, zu erzeugen und, dass ein dass eine jeweilige Energiequelle 332a, 334a, 336a jeweils dazu ausgebildet ist, um im aktiven Betriebsmodus der jeweiligen Vorrichtung ein jeweiliges Kommunikationsmodul (nicht gezeigt) und einen jeweiligen Signalgenerator 322a, 324a, 326a mit Energie zu versorgen.

Ferner sei darauf hingewiesen, dass die in Fig. 3a gezeigten Merkmale optional sind, und somit gemäß Ausführungsbeispielen individuell oder in Kombination verwendet werden können. So kann ein Turm 362a bspw. nur über einen einzelnen Leiter oder eine Vielzahl von Leitern verfügen. Die unterschiedlichen Anordnungen und Ausprägungen der Vorrichtungen 302a, 304a, 306a sind dabei nicht als einschränkend aufzufassen, sondern dienen dazu verschiedenen Ausführungsbeispiele gemäß der vorliegenden Erfindung übersichtlich zu erläutern.

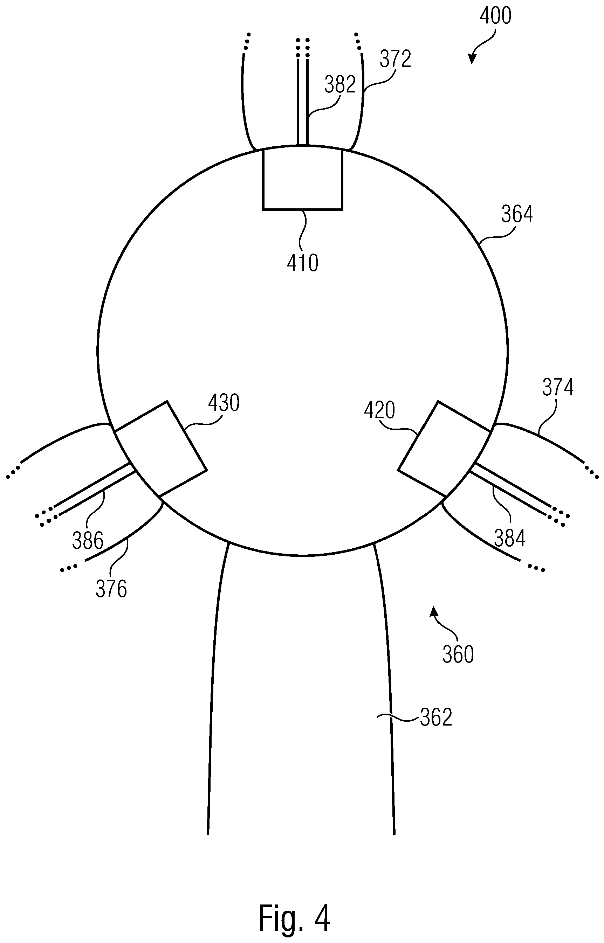

Fig. 4 zeigt ein System zur Bereitstellung von elektrischen Prüfsignalen gemäß Ausführungsbeispielen der vorliegenden Erfindung. Fig. 4 zeigt eine Windkraftanlage 360 entsprechend Fig. 3, sowie das System 400 umfassend eine Mehrzahl von Vorrichtungen 410, 420, 430 gemäß einem oder mehreren der hierin beschriebenen Ausführungsbeispiele, wobei ein jeweiliges Einkopplungsmodul einer jeweiligen Vorrichtung dazu ausgebildet ist, um ein jeweiliges elektrisches Prüfsignal zur Durchgangsprüfung eines jeweiligen Blitzableiters 382, 384, 386 in ein jeweiliges Rotorblatt 372, 374, 376 einzukoppeln. In einfachen Worten kann ein erfindungsgemäßes System 400 also eine der Anzahl von Leitungen entsprechende Vielzahl von erfindungsgemäßen Vorrichtungen umfassen. Somit kann für jede zu überprüfende Leitung eine eigene Vorrichtung bereitgestellt werden, welche dementsprechend auch individuell angesteuert, also aktiviert und deaktiviert werden kann. Einkopplungsmodule der Vorrichtungen 410, 420, 430 können dabei bspw. an einem Blitzableiter eines Rotorblattes oder in einer Zuleitung zum Rotorblatt befestigt, oder in ein Rotorblatt integriert werden.

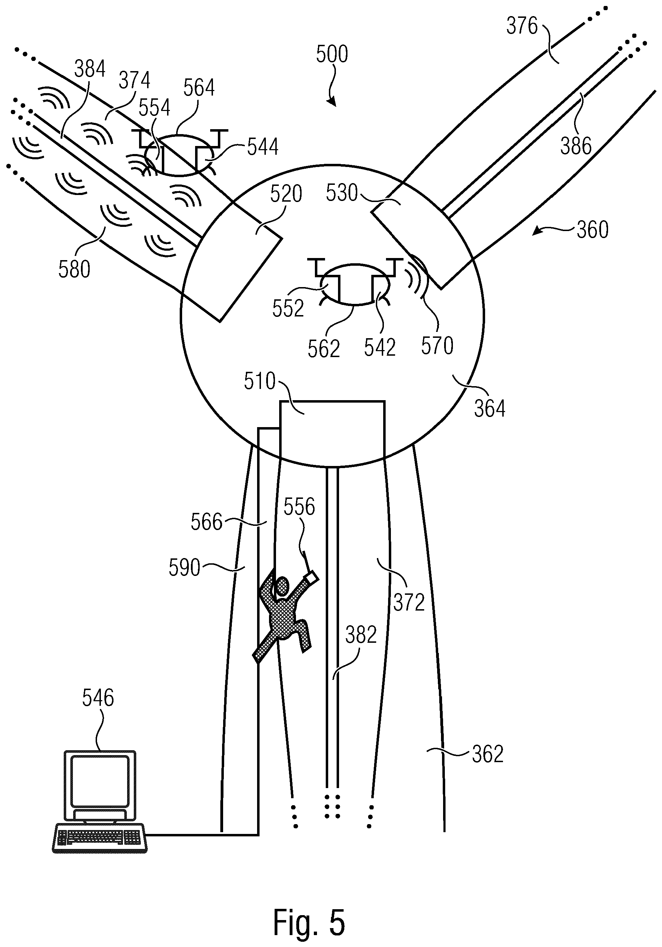

Fig. 5 zeigt ein weiteres System zur Bereitstellung eines elektrischen Prüfsignals mit weiteren optionalen Merkmalen gemäß Ausführungsbeispielen der vorliegenden Erfindung. Fig. 5 zeigt eine Windkraftanlage 360 mit den bereits im Kontext von Fig. 3 und Fig. 4 beschriebenen Merkmalen. Dabei sei darauf hingewiesen, dass eine Windkraftanlage 360 hier wiederum lediglich ein veranschaulichendes Beispiel für ein Objekt darstellt. Es sei nochmals erwähnt, dass ebenfalls Kräne, Antennenmasten, Funkmasten, große Schiffe oder beispielsweise ganze Hafenanlagen elektrische Leitungen aufweisen können, die in regelmäßigen Abständen geprüft werden müssen.

Anhand von Fig. 5 und System 500 wird im Folgenden eine Vielzahl von Ausführungsbeispielen erläutert. Hierbei sei darauf hingewiesen, dass einzelne Merkmale, Details und Funktionalitäten, sofern nicht anders erläutert, hier gemeinsam zur Verdeutlichung von erfindungsgemäßer Funktionalität hervorgehoben sind, diese jedoch nicht alle gemeinsam gleichzeitig in Ausführungsbeispielen vorhanden sein müssen.

Als Beispiel umfasst das System 500 eine Mehrzahl von Vorrichtungen gemäß einem oder mehreren der erläuterten Ausführungsbeispielen, nämlich die Vorrichtung 510, 520 und 530. Die Vorrichtungen sind dabei in der Nähe der Blitzableiter der Rotorblätter angeordnet, um mittels eines jeweiligen Einkopplungsmoduls ein Prüfsignal in das entsprechende Rotorblatt 372, 374, 376 oder, genauer gesagt, in den entsprechenden Blitzableiter 382, 384, 386, einzukoppeln.

Hierbei sei wiederum darauf hingewiesen, dass auch beispielsweise lediglich eine Vorrichtung in dem System vorhanden sein kann, welche eine Vielzahl von Einkopplungmodulen aufweist, so dass über die Vielzahl von Einkopplungmodulen das Prüfsignal beispielsweise von einem gemeinsamen Signalgenerator oder auch von einer Mehrzahl von Signalgeneratoren in die Blitzableiter 382, 384, 386 eingespeist werden können.

Ferner umfasst das System 500 eine Kommunikationseinheit, beispielsweise eine Kommunikationseinheit 542 und/oder eine Kommunikationseinheit 544 und/oder eine Kommunikationseinheit 546, die dazu ausgebildet ist, um das Aktivierungssignal und das Deaktivierungssignal an ein Kommunikationsmodul einer der Vorrichtungen 510, 520, 530 zu übermitteln.

Das System 500 umfasst ferner eine Messeinheit, beispielsweise eine Messeinheit 252 oder eine Messeinheit 554 oder eine Messeinheit 556, die dazu ausgebildet ist, um das Prüfsignal zu erfassen.

In Fig. 5 sind entsprechend mehrere Optionen für die Kommunikationseinheit und die Messeinheit und Messeinheit abgebildet, welche im Folgenden näher erläutert werden sollen. Dabei sei darauf hingewiesen, dass System und insbesondere erfindungsgemäße Verfahren derartige Einheiten sowohl einzeln, gemeinsam, in Kombination oder individuell aufweisen können. Dies soll anhand der folgenden Erläuterung näher erklärt werden.

Beispielsweise kann eine Drohne 562 zur Durchführung der Durchgangsprüfung einer elektrischen Leitung eines Objekts verwendet werden. Es sei darauf hingewiesen, dass das System 500 die Drohne 562 optional ebenfalls umfassen kann. Die Drohne kann beispielsweise mittels eines Laptops vom Boden aus gestartet werden. Die Drohne kann dazu ausgebildet sein, anschließend bspw. autonom, semi-autonom oder automatisiert oder auch durch händische Steuerung zu einer der Vorrichtungen 530 und damit beispielsweise, wie in Fig. 5 gezeigt, zur Rotornabe 364 zu fliegen. Zur Aktivierung der Vorrichtung 530 kann nun mittels der Kommunikationseinheit 542 das Aktivierungssignal an das Kommunikationsmodul der Vorrichtung 530 übermittelt werden. Entsprechend kann eine erfindungsgemäße Kommunikationseinheit dazu ausgebildet sein, wie beispielsweise die Kommunikationseinheit 542, um an einer Drohne befestigt zu werden.

Um beispielsweise ein entsprechendes Aktivierungssignal 570 empfangen zu können, kann das Kommunikationsmodul der Vorrichtung 530 in zeitlichen Abständen für eine vorbestimmte Dauer aktiviert werden. Entsprechend kann die Kommunikationseinheit dazu ausgebildet sein, um das Aktivierungssignal 570 während einer Zeitspanne, die größer ist als eine Zeitspanne zwischen zwei Aktivierungen des Kommunikationsmoduls, bereitzustellen.

Dementsprechend kann von der Vorrichtung 530 oder genauer dem Kommunikationsmodul der Vorrichtung 530 das Aktivierungssignal 570 empfangen werden, um ausgehend von dem passiven Betriebsmodus in den aktiven Betriebsmodus zu wechseln. Folglich kann ein erfindungsgemäßes Verfahren ein Übermitteln des Aktivierungssignals mittels der Kommunikationseinheit 542 an das Kommunikationsmodul während einer Zeitspanne, die größer ist als ein zeitlicher Abstand zwischen zwei Aktivierungen des Kommunikationsmoduls umfassen. Optional kann entsprechend eine Information über den Betriebszustand der Vorrichtung von dem Kommunikationsmodul der Vorrichtung 530 an die Kommunikationseinheit 542 zurückübermittelt werden. Im aktiven Betriebsmodus der Vorrichtung kann dann dementsprechend das Prüfsignal in den Blitzableiter eingeleitet werden. Ausgehend von einer aktivierten Vorrichtung kann eine Drohne, wie beispielsweise mit Drohne 564 gezeigt, automatisiert, autonom, semi-autonom oder auch händisch ein Rotorblatt 374 abfliegen. Die Drohne kann dabei eine Messeinheit aufweisen, die dementsprechend dazu ausgebildet ist, um an einer Drohne befestigt zu werden, also beispielsweise wie die Messeinheiten 552 und 554 in Fig. 5.

Es sei darauf hingewiesen, dass es sich bei Drohnen 542 und 544 und entsprechend um Kommunikationseinheiten 542 und 544 und Messeinheiten 552 und 554 jeweils um dieselben Objekte handelt, welche die hier erläuterten Schritte nacheinander ausführen.

Im Folgenden sei davon ausgegangen, dass die Vorrichtung 520 im aktivierten Zustand befindlich ist, beispielsweise durch eine vorherige Aktivierung, wie mit Drohne 562 und Rotorblatt 376 erläutert. Vorrichtung 520 kann dementsprechend mittels des zugehörigen Signalgenerators und des Einkopplungmoduls ein Prüfsignal 580 in den Leiter 384 einkoppeln. Die Einkopplung kann hierbei beispielsweise induktiv, kapazitiv oder per ohmscher schaltbarer Verbindung erfolgen.

Die Messeinheit 554 kann dabei optional dazu ausgebildet sein, um bei einem Inspektionsflug der Drohne 564 entlang des Objekts, also beispielsweise entlang des Rotorblattes 374, das Prüfsignal 580 zu erfassen. Entsprechend kann auf eine Unterbrechung des Leiters zurückgeschlossen werden, wenn ein eben solches Signal schwächer als erwartet oder nicht vorhanden ist. Anschließend kann die Drohne 564 beispielsweise wieder zu einer jeweiligen Vorrichtung, also z. B. Vorrichtung 530, wie zuvor erklärt, oder auch Vorrichtung 552 zurückkehren und dann beispielsweise in einer Position, wie mit Drohne 562 gezeigt, das Deaktivierungssignal übermitteln, um das Einkoppeln des Prüfsignals zu beenden. Dementsprechend kann ein automatisierbares Verfahren zur Durchgangsprüfung von Blitzableitern bereitgestellt werden.

Es sei darauf hingewiesen, dass mittels der Kommunikationseinheit 542 jedoch auch das Aktivierungs- und/oder Deaktivierungssignal von einer beliebigen Position aus, auf einer Flugroute der Drohne 562, 564 übermittelt werden kann, bspw. bei einem Flug von einem Rotorblatt zu einem nächsten Rotorblatt, bspw. von einer Nabe der Windkraftanlage aus, oder bspw. von einer Rotorblattspitze aus.

Allgemein ausgedrückt kann das Objekt dementsprechend mit einer Drohne 562, 564 angeflogen werden, beispielsweise automatisiert, semi-autonom, autonom oder händisch, wobei die Drohne die Messeinheit 552, 554 aufweist. Anschließend kann ein Aktivierungssignal mittels einer Kommunikationseinheit 542, 544 an ein Kommunikationsmodul einer Vorrichtung 520, 530 übermittelt werden. Hierbei sei darauf hingewiesen, dass beispielsweise auch lediglich eine einzelne Vorrichtung vorhanden sein kann, mit einem einzelnen Kommunikationsmodul, aber beispielsweise einer Vielzahl von Einkopplungmodulen zur Einkopplung des elektrischen Prüfsignals, so dass beispielsweise das Aktivierungssignal nur in eben jenes einzelne Kommunikationsmodul übermittelt wird.

Anschließend kann das Objekt mittels der Drohne abgeflogen werden und das Prüfsignal 580 oder die Vielzahl von Prüfsignalen mehrerer Rotorblätter können mittels der Messeinheit 552, 554 erfasst werden. Nach dem Abfliegen kann die eine oder die mehreren Vorrichtungen dann mittels eines Deaktivierungssignals dann wiederum in den passiven Betriebsmodus überführt werden, beispielsweise abgeschaltet werden.

Das erfasste Prüfsignal kann anschließend ausgewertet werden. Beispielsweise kann ein erfindungsgemäßes Verfahren ein Vergleichen des erfassten Prüfsignals mit einem Referenzsignal umfassen. Das Referenzsignal kann dabei beispielsweise ein theoretisches Referenzsignal sein, welches über Nenndaten des Prüfsignals und des Blitzableiters bestimmt werden kann, oder auch beispielsweise ein historisches Referenzsignal, welches beispielsweise bei einer vorherigen Messung erfasst wurde. Somit kann insbesondere auch eine Information über einen Trend, also beispielsweise eine zeitliche Degradation des Blitzableiters, bereitgestellt werden, um beispielsweise Wartungen zu prädizieren, die vielleicht noch nicht sofort notwendig sind, aber auf lange Sicht durchgeführt werden sollten. Somit kann eine Information über eine Beschädigung der elektrischen Leitung bzw. des Blitzableiters bestimmt werden.

Ganz allgemein kann es sich bei den durch die Messeinheit gespeicherten Daten neben dem eigentlichen erfassten Wert des Prüfsignals zusätzlich und zumindest eines aus einer Zeitinformation einer absoluten Positionsinformation der Drohne eine Abstands- und/oder eine Lageinformation der Drohne bezüglich des Rotorblattes handeln. Dazu kann die Drohne beispielsweise einen GPS-Empfänger aufweisen oder mittels relativer Lokalisierungssysteme die eigene Position bestimmen.

Das Ergebnis einer derartigen Auswertung auf Basis der erfassten Information kann dazu verwendet werden, eine Beschädigungsstelle zu lokalisieren und einen Austausch oder eine Reparatur zu planen. Dabei können beispielsweise Kletterer 566 zum Einsatz kommen. Zur besonders präzisen Lokalisierung kann dabei eine Messeinheit 556 beispielsweise ein tragbares Gerät sein, so dass ein Kletterer in unmittelbarer Nähe zum Rotorblatt eine Beschädigungsstelle genauer bestimmen kann. Als Beispiel ist hierbei zur Aktivierung der Vorrichtung 510 eine Signalleitung 590 gezeigt. Dementsprechend kann beispielsweise drahtgebunden das Aktivierungssignal mittels einer Kommunikationseinheit 546 zum Kommunikationsmodul der Vorrichtung 510 übermittelt werden. Im Fall der Windkraftanlage kann es sich hierbei beispielsweise, wenn die Vorrichtung 510 fest mit der Rotornabe verbunden ist, um eine elektrische Leitung handeln, die entlang des Turms bis zum Fuß der Anlage verlegt ist. Somit kann beispielsweise ein Laptop, der auch beispielsweise zur Steuerung einer Drohne verwendet werden kann, zur Aktivierung der Vorrichtung 510 verwendet werden. Dementsprechend sei darauf hingewiesen, dass eine entsprechende drahtgebundene Signalübertragung auch mit Ausführungsbeispielen unter Verwendung von Drohnen genutzt werden kann. Alternativ kann beispielsweise jedoch auch ein Kletterer 566 eine tragbare Kommunikationseinheit mitführen, mit der eine entsprechende Vorrichtung 510, wie im Zuge der Drohne 562 erläutert, aktiviert werden kann.

Zusammenfassend kann also das Aktivierungssignal drahtgebunden oder drahtlos mittels einer Kommunikationseinheit an das Kommunikationsmodul einer Vorrichtung oder der Vorrichtung, beispielsweise falls nur eine Vorrichtung in der Windkraftanlage, mit einer Vielzahl von Einkopplungsmodulen verbaut ist, übermittelt werden. Anschließend kann beispielsweise ein Kletterer den Blitzableiter mittels eines Handgeräts 556 abtasten und ein entsprechendes Prüfsignal erfassen. Nach der Erfassung des Prüfsignals kann die entsprechende Vorrichtung 510 mittels des Kommunikationsmoduls wiederum deaktiviert werden. Eine Messeinheit 556 kann dabei beispielsweise dazu in der Lage sein, die gemessenen Daten drahtlos zu übermitteln, um beispielsweise eine unmittelbare Auswertung während der Inspektion zu ermöglichen, so dass beispielsweise direkt eine exakte Positionsbestimmung der Beschädigungsstelle möglich ist und eine Reparatur direkt eingeleitet werden kann.

Hierbei sei nochmals darauf hingewiesen, dass im Zuge der Erläuterung zu Fig. 5 mehrere optionale Vorgehensweisen gemäß der Erfindung vorgestellt wurden, diese jedoch einzeln oder in Kombination verwendet werden können. So kann beispielsweise mit einer Drohne nacheinander eine Vielzahl von Vorrichtungen aktiviert werden und jeweils nacheinander iterativ ein Prüfsignal in jeweils eines der Rotorblätter eingekoppelt werden, um diese Rotorblätter jeweils iterativ nacheinander abzufliegen und nach jedem Abfliegen jeweils die aktivierte Vorrichtung wieder zu deaktivieren, um eine weitere Vorrichtung zu aktivieren, bis alle entsprechenden Blitzableiter inspiziert wurden. Ferner kann jedoch auch eine Drohnenstaffel zum Einsatz kommen, so dass alle Vorrichtungen gleichzeitig aktiviert werden und mehrere Rotorblätter oder alle Rotorblätter gleichzeitig abgeflogen werden, oder auch im Fall einer einzeln vorhandenen Vorrichtung eben jene Vorrichtung aktiviert wird, so dass die Vorrichtung eine Mehrzahl von Einkopplungsmodulen aktiviert, um mithilfe von einem oder mehreren Signalgeneratoren jeweilige Prüfsignale in jeweilige Blitzableiter einzuleiten. Das Abfliegen kann, wie zuvor erläutert, sowohl händisch, automatisiert als auch autonom oder semi-autonom vonstattengehen. Ein semi-autonomer Flug kann dabei bspw. eine Korrektur einer, z.B. vorbestimmten, Flugrichtung oder eines Abstands (bspw. vom Objekt) über z.B. ein zusätzliches Messystem, bspw. Lidar umfassen. Alternativ kann natürlich auch händisch, also beispielsweise durch Kletterer, das Aktivieren und Deaktivieren durchgeführt werden, ebenso wie die Abtastung des entsprechenden Leiters der Windkraftanlage.

Im Folgenden werden weitere Ausführungsbeispiele, und zuvor erläuterte Ausführungsbeispiele, zusammengefasst in anderen Worten, für Objekte in Form von Windkraftanlagen oder Rotorblättern von Windkraftanlagen, diskutiert.

Gemäß einigen Ausführungsbeispielen kann es sich bei dem Einkopplungsmodul beispielsweise um eine Zange, bspw. eine Induktionszange handeln. Das Kommunikationsmodul kann bspw. als Funkmodul oder integriertes Funkmodul ausgebildet sein, wobei das Funkmodul dazu ausgebildet sein kann die Vorrichtung bspw. aus dem passiven Betriebsmodus, bspw. einem Sleep Mode in den aktiven Betriebsmodus, bspw. einem Active Mode oder einem Aktiven Mode, zu versetzen oder umzuschalten.

Zur Erfassung des Prüfsignals kann bspw. eine Drohne mit einer Messeinheit zum Einsatz kommen, sodass bspw. nach einem Inspektionsflug, bspw. mittels des Funkmoduls, die Vorrichtung wieder in den passiven Betriebsmodus, also bspw. den Sleep Mode versetzt werden kann.

Beispielsweise für die Prüfung einer Blitzschutzanlage einer Windkraftanlage besteht die Kernidee gemäß derartiger Ausführungsbeispielen in der nicht invasiven Einspeisung eines elektromagnetischen Feldes in die Blitzschutzanlage sowie im berührungslosen, bspw. autonomen, Abflug der Rotorblätter mittels der Drohne, die mit einer Messeinheit, also bspw. einem speziellen Sensor zur Feldmessung, ausgestattet sein kann. Die so erfolgte Messung kann mittels spezieller Messtechnik sowie mathematisch/algorithmischer Verarbeitung schnell, effizient und genau die Funktionsfähigkeit der Blitzschutzanlage feststellen.

In einfachen Worten basieren Ausführungsbeispiele also auf der bspw. induktiven Einspeisung eines elektrischen Feldes in das Blitzschutzsystem des Rotorblattes, sowie der Messung des abgestrahlten elektrischen Feldes mit einer Messeinheit, bspw. einem Feldsensor an einer Drohne.

Die Lokalisierung eventuell entdeckter Schadstellen ist gemäß Ausführungsbeispielen präzise möglich und kann bspw. mit einer weiteren Messeinheit, z.B. einem gesonderten Handsensor zum Zwecke einer Reparatur, auch nachträglich jederzeit nachvollzogen werden.

Wie bereits zuvor erläutert kann die Energiequelle bspw. als austauschbarer Energiespeicher ausgebildet sein. Hierzu kann bspw. eine Lithium Batterie oder ein Lithium Akkumulator zum Einsatz kommen. (Hierbei sei nochmals darauf hingewiesen, dass ganz allgemein gemäß Ausführungsbeispielen jedoch auch bspw. alternativ ein Kabel zur Energieversorgung der Vorrichtung mittels einer externen Leistungsversorgung verwendet werden kann).

Als Beispiel kann ein solcher Energiespeicher ca. 8000 mAH (bspw. mit einer Toleranz von bis zu +/-5% oder mit einer Toleranz von bis zu +/-10% oder mit einer Toleranz von bis zu +/-50% oder mit einer Toleranz von bis zu +/-100% oder mit einer Toleranz von bis zu +/-1000%), bspw. bei ca. 12 V (bspw. mit einer Toleranz von bis zu +/-5% oder mit einer Toleranz von bis zu +/-10% oder mit einer Toleranz von bis zu +/-50% oder mit einer Toleranz von bis zu +/-100% oder mit einer Toleranz von bis zu +/- 1000%) umfassen.

Bei besonders bevorzugten Ausführungsbeispielen kann ein solcher Energiespeicher bspw. mit geringem Aufwand, bspw. mit einem Handgriff, ausgetauscht werden. Hierzu kann die Vorrichtung bspw. einfache Steck- und Einrastverbindungen für einen solchen Energiespeicher aufweisen.

Wie bereits zuvor erläutert kann das Kommunikationsmodul, also bspw. das Funkmodul, optional im passiven Betriebsmodus in zeitlichen Abständen für eine vorbestimmte Dauer zum Erhalten des Aktivierungssignals aktiviert werden. Dabei kann ein entsprechender austauschbarer Energiespeicher bspw. für eine Einsatzdauer über viele Jahre ausgelegt sein, sodass eine erfindungsgemäße Vorrichtung über lange Zeiträume ohne besonderen Wartungsaufwand auskommen kann.

Beispielsweise kann ein Stromverbrauch im passiven Betriebsmodus, also bspw. im Sleepmode sich wie folgt zusammen setzen:
Bspw. kann die Elektronik ca. 15 Mikro Ampere im Sleep Mode benötigen und sie kann alle 60 sec für ca., 0,1 sec zur Abfrage des Funksignals "geweckt" werden - ca. 15 mA für 0,1 sec. Daraus ergibt sich ein jährlicher Verbrauch von ca. 500mAh bzw. 2000 mAh für 4 Jahre.

Ein Stromverbrauch im aktiven Betriebsmodus, bspw. einem Inspektionsmodus, kann sich für das Beispiel der Blitzableiterinspektion an einer Windkraftanlage wie folgt zusammensetzen:
Ca. 800 mA d.h. bei maximal 15 Min Inspektionszeitzeit pro Flügel d.h. ca. 4000mAh für ca. 20 Inspektionen.

Dementsprechend kann für das vorige Beispiel des Energiespeichers mit ca. 8000 mAh bei ca. 12 Volt, wenn bspw. 2-3 Inspektionen pro Jahr angesetzt oder berechnet werden, z.B. nach Blitzschlag (gesetzl. Vorgeschrieben sind bspw. maximal 1 Inspektion alle 2 Jahre), und wenn eine gewisse Selbstentladung des Energiespeichers, also bspw. der Li Batterie berücksichtigt wird, die Batterie ca. lediglich alle 6 Jahre (normaler vorgeschriebener Service in der Anlage ist bspw. alle 2 Jahre) im Rahmen des vorgeschriebenen Services ausgetauscht werden müssen.

Somit kann eine erfindungsgemäße Vorrichtung über lange Zeiträume ohne Wartung auskommen. Wie zuvor erläutert kann optional zusätzlich während, bspw. jeder oder zumindest einiger Inspektionen (z.B. im aktiven Betriebsmodus, also wenn die Vorrichtung aktiv ist) bspw. sicherheitshalber der Ladezustand des Energiespeichers (z.B. Batterie), über das Kommunikationsmodul (z.B. Funkmodul) von der Drohne optional jedes Mal mit abgefragt werden.

Gemäß weiteren Ausführungsbeispielen kann, wie bereits zuvor erläutert, die Vorrichtung, oder bspw. auch nur das Einkopplungsmodul, bspw. in Form einer Induktionszange, fest mit der Windkraftanlage oder einem Rotorblatt der Windkraftanlage verbunden werden. Bspw. kann die Vorrichtung oder das Einkopplungsmodul der Vorrichtung am Blitzableiter eines Rotorblattes und/oder in einer Zuleitung zum Rotorblatt befestigt werden oder die Vorrichtung oder das Einkopplungsmodul kann bspw. in ein Rotorblatt integriert werden.

Bspw. kann somit zur Inbetriebnahme der Vorrichtung, bspw. einer obig beschriebenen Vorrichtung, z.B. das Einkopplungsmodul, bspw. in Form einer Induktionszange, von einem Serviceteam einmalig am Blitzleiter am Flügelanfang befestigt (z.B. verklebt) werden und kann dort während des gesamten Lifecycles (Lebenszyklus) der Anlage (Windkraftanlage bspw. ca. 25 Jahre) verbleiben. Das Einkopplungsmodul kann bspw. in der Nabe der Windkraftanlage, an einem Rotorblattflansch oder in einem Rotorblatt selbst integriert werden.

Ein großer Vorteil von Ausführungsbeispielen mit galvanischer Trennung zwischen Einkopplungsmodul und Leitung des Objekts, also bspw. mit induktiver Einkopplung also bspw. eines erfindungsgemäßen nicht invasivem Induktionsverfahren ist, dass die Vorrichtung (z.B. das Einkopplungsmodul in Form einer Induktionszange) nicht direkt (elektrisch) mit dem Blitzleiter verbunden sein muss, sodass es bspw. bei einem Blitzeinschlag nicht zu einer Beschädigung des Systems bzw. der Vorrichtung kommen kann. Optional können bspw. zwischen Einkopplungsmodul (Gemäß Ausführungsbeispielen ganz allgemein bspw. ausgebildet als Induktionsspule oder Induktionsring) und Ausgangstransistoren (bspw. des Signalgenerators) zum zusätzlichen Schutz Schutzdioden, bspw. in Form von sogenannten Transil Dioden, angeordnet oder angebracht sein. Entsprechende Ausführungsbeispiele können dabei die Verwendung solcher Dioden erst ermöglichen.

Im Folgenden soll ein Beispiel für einen Inspektionsablauf gemäß einem Ausführungsbeispiel an einer Windkraftanlage zur Blitzschutzmessung gemäß Ausführungsbeispielen erläutert werden. Dazu kann bspw. eine erfindungsgemäße Vorrichtung wie obig erläutert zum Einsatz kommen. Dabei kann bspw. an jedem Rotorblatt, oder einfach ausgedrückt Flügel, der Windkraftanlage eine Vorrichtung bspw. mit einem Einkopplungsmodul in Form einer Zange, also bspw. einer Induktionszange, angeordnet sein. Ferner kann das Erfassen des Prüfsignals mittels einer Drohne umfassend eine Messeinheit realisiert werden. Somit kann bspw. die folgenden Schrittfolge gemäß Ausführungsbeispielen durchgeführt werden.
1. Die Drohne fliegt, z.B. autonom, an die Flügelnabe der Windkraftanlage (Wie zuvor erläutert bildet dies nur eine Option gemäß Ausführungsbeispielen, so kann bspw. auch eine Rotorblattspitze angeflogen werden, ferner kann optional ein händischer, automatisierter, oder semi-autonomer Flug ebenfalls durchgeführt werden).
2. Die Drohne initiiert das Aktivierungssignal, bspw. ein Funksignal, um die erste Vorrichtung (z.B. Flügel 1) zu aktivieren, oder einfach ausgedrückt zu "wecken". Dabei wartet die Drohne für ein definiertes Zeitintervall, bspw. für ca. 75 sec, um auch wirklich den Weckintervall (z.B. alle 60 sec) zu erwischen (Anders ausgedrückt kann also eine Wartezeit, bspw. eine Zeit in der das Aktivierungssignal übermittelt wird länger sein, als ein Zeitraum zwischen zwei Aktivierungen des Kommunikationsmoduls im passiven Betriebsmodus). Zusätzlich bekommt sie optional über das Funkmodul Feedback von der Vorrichtung, dass die Vorrichtung im aktiven Betriebsmodus, also bspw. aktiv, ist
3. Die Drohne fliegt, z.B. autonom (oder händisch, oder automatisiert, oder semi-autonom), den Flügel ab und kehrt an die Nabe zurück (oder bspw. an die Rotorblattspitze zurück oder an ein weiteres Rotorblatt, oder verbleibt nach einem Start von der Nabe aus an der Flügelspitze, oder verbleibt nach einem Start von der Flügelspitze an der Nabe) und schaltet die Vorrichtung wieder in den passiven Betriebsmodus, also bspw. den Sleep Mode
4. Danach weckt die Drohne die nächste Vorrichtung (bspw. des nächsten Rotorblattes) usw.

Im Folgenden sollen anhand eines Beispiels Vorteile von Vorrichtungen umfassend Einkopplungsmodule in Form von Zangen, bspw. Blitzschutzzangen, gemäß Ausführungsbeispielen diskutiert werden, die dauerhaft mit der Windkraftanlage verbunden sind.

Bei manchen Vorgehensweisen kann es notwendig sein, dass (bspw. aus Sicherheitsgründen gesetzl. vorgeschrieben, wenn Techniker aus der Nabe in den Flügelansatz klettern müssen) zwei Serviceleute mit dem Aufzug in die Gondel (Nabe) fahren müssen, um dann dort an den jeweiligen Flügelansätzen (Flansch) die Zange am Blitzschutzkabel befestigen zu können.

Danach kann die Energiequelle, bspw. in Form eines Netzteils, jeweils über ein z.B. 10m langes Kabel an jede der drei Zangen (je eine Vorrichtung pro Rotorblatt) angeschlossen werden und die Zangen können von einem Servicetechniker am Netzteil bspw. über einen Drehschalter je nach Position der Drohne (Flügel 1,2 oder 3) der Reihe nach ein/aus geschaltet werden.

Die Drohne kann dann mit einer Geschwindigkeit von bspw. 0,25 m/sec (also bspw. einer Geschwindigkeit von zumindest 0,1 m/sec und höchstens 0,3 m/sec oder von zumindest 0,2 m/sec und höchstens 0,3 m/sec) am Flügel entlang fliegen (Abstand bspw. ca. 5 m (also bspw. einem Abstand von zumindest 4 m und höchstens 6 m oder von zumindest 1 m und höchstens 10 m) - optional mittels händischem, automatisierten, autonomem oder semi-autonomen Flug) - bspw. vom Flügelansatz (Flansch) bis zur Flügelspitze und kann dabei das abgestrahlt elektrische Feld des Prüfsignals scannen. D.h. bei einer Flügellänge von z.B. 60 Metern dauert die gesamte Blitzschutzinspektion für einen Flügel ca. 4 Minuten. Danach kann die Drohne ebenfalls optional autonom (oder händisch, oder automatisiert, oder semi-autonom) mit einer höheren Geschwindigkeit zurück zur Nabe (dafür z.B. ca. 1 Minute Zeitdauer) oder zu einem anderen Punkt der Windkraftanlage, bspw. einer benachbarten Flügelspitze, fliegen. Danach kann der Service-Ingenieur auf die nächste Zange umschalten und der nächste Flügel kann inspiziert werden. Das bedeutet, dass die gesamte Inspektion (Flugzeit der Drohne ohne Einrüstung) inkl. An/Abflug bspw. ca. 25 Minuten dauern kann.

Optional können ganz allgemein gemäß Ausführungsbeispielen Bereiche des Objekts im Besonderen oder zusätzlich inspiziert werden. Bspw. können zusätzlich einzelne Bereiche des Flügels, z.B. Rezeptoren, mit inspiziert werden. Dadurch, kann sich die Inspektionszeit allerdings um mehrere Minuten erhöhen.

Vorteile von Ausführungsbeispielen, bei denen die Vorrichtung dauerhaft mit dem Objekt verbunden ist, sind dabei bspw., dass zum Aufbau und Abbau der Vorrichtungen, und damit also bspw. der Zangen, nicht zwei Servicetechniker mit dem Aufzug in den Turm fahren müssen. Somit kann entfallen, dass ein Servicetechniker wieder runterfahren muss, um die Drohne zu bedienen, während der andere Servicetechniker von der Nabe aus das Netzteil bedient. Entsprechend kann auch eingespart werden, dass nach der erfolgten Inspektion der zweite Techniker wieder nach oben fahren muss, um die Zangen wieder zu entfernen.

Dadurch sind große Zeitersparnisse möglich. Dabei sei jedoch darauf hingewiesen, dass Ausführungsbeispiele mit Vorrichtungen, die bspw. wie zuvor erläutert auf- und abgebaut werden müssen, gegenüber konventionellen Ansätzen, bspw. mit Seilkletterern immer noch große Vorteile aufweisen.

Bspw. kann eine durchschnittliche Inspektion mit einem erfindungsgemäßen System ca. 1,5 Stunden (gegenüber der herkömmlichen Methode mit Seilkletterer ca. 8 Stunden) dauern. Diese Zeitdauer ist entsprechend Ausführungsbeispielen mit dauerhaft am Objekt angeordneten Vorrichtungen weiter verringerbar.

Ausführungsbeispiele weisen somit insbesondere bei schwer zugänglichen Objekten große Vorteile auf. Bei Offshore Anlagen (Anfahren mit dem Schiff, Höhe der Anlagen) kann eine komplette Inspektion mehrere Tage dauern. - Wichtig neben der Personalkosten spielen die Ausfallkosten durch Stillstand während der Inspektion eine wesentliche Rolle (bspw. bis zu € 2000 pro Stunde). Gemäß Ausführungsbeispielen sind somit große Zeit- und Kostenersparnisse möglich.

Erfindungsgemäße Verfahren ermöglichen somit zuvor beschriebene Nachteile zu beheben und ein extrem effektives System zur Durchgangsprüfung eines Blitzableiters einer Windkraftanlage bereitzustellen.

Gemäß weiterer Ausführungsbeispiele der vorliegenden Erfindung kann der Signalgenerator an der Wurzel eines Rotorblatts ein abgestimmtes Signal in die Blitzableiter induzieren und dabei entlang des Rotorblatts ein für die Messung bspw. notwendiges Prüfsignal, bspw. ein nahezu konstante elektrische Nahfeld, innerhalb eines von der Netzagentur zugelassenen Frequenzbereiches, erzeugen. Das Signal kann gemäß Ausführungseispielen nicht invasiv in das Blitzschutzkabel induzieret werden.

Gemäß Ausführungsbeispiele, bspw. gemäß obig erläuterter Ausführungsbeispiele, kann die Vorrichtung, z.B. ein Einkopplungsmodul in Form einer Induktionszange, oder z.B. ein Einkopplungsmodul in Form eines Induktionsrings aufweisen.

Bspw. beim Neubau einer Windkraftanlage kann ein Induktionsring direkt in ein Rotorblatt integriert werden. Einfach ausgedrückt kann ein entsprechender Induktionsring über einen Blitzableiter des Rotorblattes geschoben werden. Alternativ kann bspw. ein Kabel bei einer bestehenden Anlage aufgetrennt werden um den Induktionsring anzubringen. Ein Induktionsring kann Vorteile im Hinblick auf eine Signalqualität eines eingespeisten Prüfsignals aufweisen. Ferner kann eine Einspeisung mittels Induktionsring auch besonders robust durchgeführt werden.

Eine Induktionszange kann bspw. dazu ausgebildet sein, um einen Blitzableiter nur teilweise zu umschließen (also bspw. eine Zange mit einem offenen Ende sein), um das Prüfsignal zu induzieren. Somit müssen bspw. bei bestehenden Anlagen keine Kabel aufgetrennt (gegenüber z.B. gängigen Verfahren mit Hilfe von Durchgangsmessungen, bspw. ohmschen Durchgangsmessungen) oder irgendwelche anderen Eingriffe vorgenommen werden.

Gemäß derartiger Ausführungsbeispiele kann der Signalgenerator dabei direkt über einen, an einen entsprechenden Induktionsring oder an eine entsprechende Induktionszange optimierten, und über Impedanz z.B. exakt oder zumindest näherungsweise angepassten Anschluss verfügen.

Evtl. Abweichungen von einem bspw. Standard oder defaultmäßig vorab eingestellten Impedanz Wert (z.B. verursacht durch unterschiedliche Länge der Blitzschutzleitungen, verzweigte Blitzschutzstrukturen usw.) können optional automatisch von einer Ausgangsstufe des Signalgenerator angepasst werden. Jede Vorrichtung bspw. umfassend eine Induktionszange kann optional über ein eigenes Kommunikationsmodul in Form eines Funkmodul (z.B. mit 868 MHz, ISM Radio) verfügen und kann vom Boden aus von einem Operator per Funk zur Messung einzeln angesteuert werden.

Dies hat den Vorteil, dass bspw. alle drei Rotorblätter einer Windkraftanlage vor der Messung gleichzeitig angeschlossen werden können und für die eigentliche Messung die Signaleinspeisung in die Rotorblätter über Funk vom Boden aus vom Operator einzeln angesteuert werden kann. Hierbei sei angemerkt, dass die Vorrichtungen, bspw. Einkopplungsmodule der Vorrichtungen in Form von Induktionszangen, auch dauerhaft an den Blitzableitern der Rotorblättern oder an entsprechenden Zuleitungen angebracht sein können.

Zur Vermeidung von Messungenauigkeiten durch Störungen auf dem bspw. stark genutzten verwendeten ISM Band (13,56 MHz) kann zusätzlich optional auf das Prüfsignal eine Kennung moduliert werden, die vom Sensor-Prozessor (bspw. der Messeinheit) herausgefiltert und für die Berechnung der Werte ausschließlich verwendet wird. Einflüsse auf die Messungen durch fremde Signale oder Störungen können dadurch bspw. sicher eliminiert werden.

Optional können auch weitere, z.B. alternative, Frequenzen, bspw. Funkfrequenzen und/oder, z.B. getaktete, Niederfrequenzen verwendet werden.

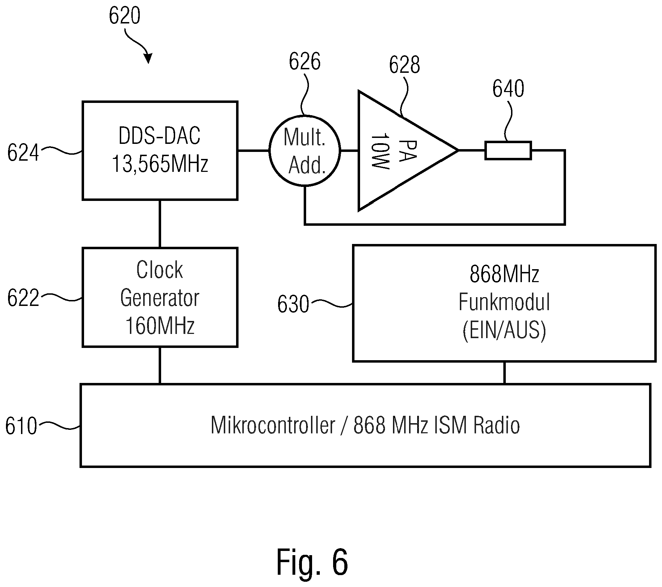

Fig. 6 zeigt ein schematisches Blockschaltbild von Elektronik einer Vorrichtung gemäß Ausführungsbeispielen der vorliegenden Erfindung. Fig. 6 zeigt einen Mikrocontroller 610, der bspw. dazu ausgebildet ist, um das Kommunikationsmodul 630 zu steuern, also beispielsweise das Kommunikationsmodul 630 einzuschalten (bspw. für den aktiven Betriebsmodus oder für ein zyklisches Bereithalten zum Empfangen des Aktivierungssignals im passiven Betriebsmodus) und/oder auszuschalten (bspw. für den passiven Betriebsmodus). Als optionales Beispiel ist das Kommunikationsmodul 630 ein Funkmodul, welches dazu ausgebildet ist auf einer Frequenz von 868 MHz zu senden und/oder zu empfangen. Ferner umfass die Elektronik der Vorrichtung einen Signalgenerator 620, der als optionale Merkmale einen Taktgeber 622 (Clock Generator) mit einer optionalen Taktfrequenz von 160 MHz, einen Direct Digital Synthesis (direkte digitale Synthese)-Digital/Analog Wandler (DDS-DAC), der wie optional dargestellt dazu ausgebildet ist ein Analogsignal, bspw. ein sinusförmiges Analogsignal mit einer Frequenz von 13,565 MHz bereitzustellen, sowie einen Multiplizierer und/oder Addierer 626 (Mult. Add.) und einen Signalverstärker 628 (power amplifier - PA 10W), z.B. mit einer Leistung von zumindest 1 Watt und höchstens 20 Watt, bspw. mit einer Leistung von 10 Watt (z.B. mit einer Toleranz von zumindest +/-5%) oder z.B. mit einer Leistung von zumindest 1 Watt und höchstens 5 Watt bspw. mit einer Leistung von 2 Watt (z.B. mit einer Toleranz von zumindest +/-5%).

In dem Beispiel von Fig. 6 herrscht als optionales Merkmal eine Impedanzanpassung an die Leitung des Objekts, sodass das Einkopplungsmodul und die Leitung des Objekts als ohmscher Widerstand 640 repräsentiert sind.

Ganz allgemein kann es sich bspw. bei einer Endstufe des Signalgenerators um eine differentielle Endstufe handeln.

Im Folgenden werden Einkopplungsmodule gemäß Ausführungsbeispielen nochmals in anderen Worten und mit weiteren optionalen Details erläutert

Wie zuvor erläutert kann gemäß Ausführungsbeispielen das Prüfsignal nach einem nicht invasiven erfindungsgemäßen Verfahren mit Hilfe einer Vorrichtung umfassend ein Einkopplungsmodul in Form einer Induktionszange, eines Induktionsrings oder Messrings in den Leiter der Windkraftanlage in Form eines Blitzschutzkabels induziert werden.

Besonders bevorzugte Ausführungsbeispiele umfassen dabei Einkopplungsmodule in Form von Induktionszangen. Derartige Verfahren können eine Reihe signifikanter Vorteile aufweisen:
a) Das Blitzschutzkabel muss nicht unterbrochen bzw. von der Erdung abgetrennt werden. Die Induktionszange kann bspw. an einer zugänglichen Stelle unter das Kabel geschoben werden.
b) Falls das Kabel fest einlaminiert ist, kann die Induktionszange auch einfach auf das Kabel gelegt werden und muss dann lediglich befestigt werden (z.B. mittels Klebeband).
c) Das Signal (Generatorausgang) wird bspw. nur einmalig an die Induktionszange angepasst, folglich treten bspw. keine Probleme mit Falschanpassungen inkl. Stehwellen bei unterschiedlichen Rotorblattaufbauten und Längen auf.
d) Bei optimaler oder zumindest näherungsweise optimaler Anpassung keine oder nur sehr wenige Schwingungen oder Störwellen - das Signal kann sich bspw. nur oder im Wesentlichen im vorgegebenen z.B. extrem schmalbandigen Frequenzbereich ausbreiten.
e) Gleichmäßiges, wiederholbares Messverhalten bei gleichen Blattkonstruktionen.

Gemäß Ausführungsbeispielen kann das entlang des Rotorblattes entstehende Prüfsignal, bspw.. ein senkrecht abstrahlendes Feld mit der Feldstärke E (lineares Nahfeld) dabei bspw. quadratisch zum Abstand Drohne-Rotorblatt abnehmen. Das Gegenstück, also bspw. die Messeinheit, kann ein hochempfindlicher elektrischer Feldsensor, bspw. ein 1D-, 2D-, oder 3D-Feldsensor z.B. mit extrem niedriger Bandbreite und hoher Samplingrate bilden, der in die optional autonom (oder bspw. händisch oder automatisiert oder semi-autonom) fliegende Drohne als Payload integriert sein kann. Empfängt der Sensor kein Signal oder eine unzureichende Signalstärke an der Rotorblattspitze, so kann der Blitzableiter entlang des Rotorblatts beschädigt oder unterbrochen sein.

Gemäß einigen Ausführungsbeispielen kann der Leiter einen (geerdeten) Monopol bilden - der Leiter muss bspw. nicht aufgetrennt werden, sondern kann mit der Erdung verbunden bleiben - und der Signalgenerator des Prüfsystems, also der Vorrichtung, kann bspw. vorzugsweise bei einer Frequenz von 13,56 MHz im Kurzwellenband ISM arbeiten (bspw. mit einer Toleranz von bis zu +/-5% oder mit einer Toleranz von bis zu +/-10% oder mit einer Toleranz von bis zu +/-50% oder mit einer Toleranz von bis zu +/-100% oder mit einer Toleranz von bis zu +/- 1000%).

Das durch die Induktion erzeugte Prüfsignal, bspw. ein senkrecht stehendes konstantes elektrisches Nah-Feld, kann durch eine Messeinheit, bspw. durch einen Feldsensor an einer Drohne, erfasst werden, die das Rotorblatt bspw. abfliegt und basierend auf dem abgestrahlten Feld eine Durchgangsprüfung des Blitzableiters durchgeführt werden.

Richtung (z.B. bei Verwendung eines 3D-Feldsensors) und Intensität der erfassten Feldstärke können bspw. ausgewertet werden, um eine Unterbrechung des Leiters zu bestimmen. Ergibt die Messung bspw. ein in vorbestimmten Toleranzen kontinuierliches Feld, so kann auf eine nicht-unterbrochene Leitung geschlossen werden, also einen funktionsfähigen Blitzableiter. Weicht die Feldstärke an einer oder mehreren Positionen entlang des Leiters von einem vorgegebenen Bereich ab, so kann bspw. auf eine unterbrochene Leitung geschlossen werden.

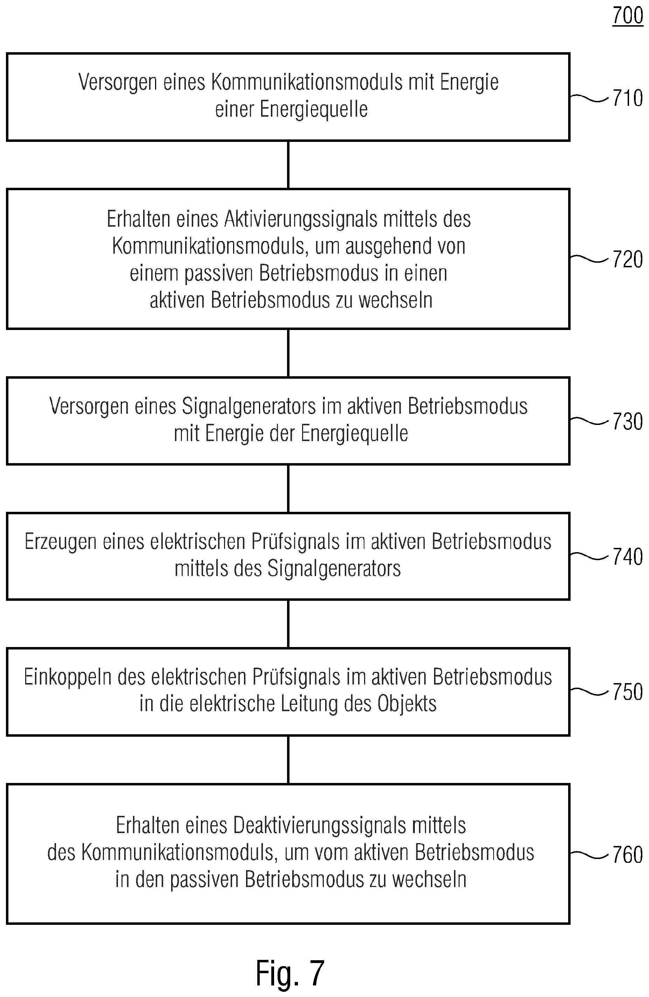

Fig. 7 zeigt ein schematisches Blockdiagramm eines Verfahrens gemäß Ausführungsbeispielen der vorliegenden Erfindung. Fig 7 zeigt ein Verfahren 700 zur Durchführung einer Durchgangsprüfung einer elektrischen Leitung eines Objekts, umfassend Versorgen (710) eines Kommunikationsmoduls mit Energie einer Energiequelle und Erhalten (720) eines Aktivierungssignals mittels des Kommunikationsmoduls, um ausgehend von einem passiven Betriebsmodus in einen aktiven Betriebsmodus zu wechseln und Versorgen (730) eines Signalgenerators im aktiven Betriebsmodus mit Energie der Energiequelle und Erzeugen (740) eines elektrischen Prüfsignals im aktiven Betriebsmodus mittels des Signalgenerators und Einkoppeln (750) des elektrischen Prüfsignals im aktiven Betriebsmodus in die elektrische Leitung des Objekts und Erhalten (760) eines Deaktivierungssignals mittels des Kommunikationsmoduls, um vom aktiven Betriebsmodus in den passiven Betriebsmodus zu wechseln.

Alle hierin aufgeführten Aufzählungen der Materialien, Umwelteinflüsse, elektrischen Eigenschaften und optischen Eigenschaften sind hierbei als beispielhaft und nicht als abschließend anzusehen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungs-beispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren auf-gezeichnet ist. Der Datenträger, das digitale Speichermedium oder das computerlesbare Medium sind typischerweise gegenständlich und/oder nichtvergänglich bzw. nicht-vorübergehend.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vorrichtung (100, 200, 300, 302a, 304a, 306a, 410, 420, 430, 510, 520, 530) zur Bereitstellungen eines elektrischen Prüfsignals (580), zur Durchführung einer Durchgangsprüfung einer elektrischen Leitung (382, 382a, 384, 384a, 386, 388a, 389a) eines Objekts (360, 360a, 362a, 372, 372a, 374, 374a, 376, 376a), umfassend:
ein Kommunikationsmodul (110, 310), das ausgebildet ist,
um ein Aktivierungssignal (570) zu erhalten, um die Vorrichtung von einem passiven Betriebsmodus in einen aktiven Betriebsmodus zu versetzen, und
um ein Deaktivierungssignal zu erhalten, um die Vorrichtung von dem aktiven Betriebsmodus in den passiven Betriebsmodus zu versetzen; und
einen Signalgenerator (120, 320, 322, 322a, 324, 324a, 326, 326a), der ausgebildet ist, um im aktiven Betriebsmodus das elektrische Prüfsignal zu erzeugen;
eine Energiequelle (130, 330, 332, 332a, 334, 334a, 336, 336a), die ausgebildet ist, um das Kommunikationsmodul und den Signalgenerator mit Energie zu versorgen, und
ein Einkopplungsmodul (140, 240, 342, 342a, 344, 344a, 346, 346a), das ausgebildet ist,
um im aktiven Betriebsmodus das elektrische Prüfsignal in die elektrische Leitung des Objekts einzukoppeln.

2. Vorrichtung (100, 200, 300, 302a, 304a, 306a, 410, 420, 430, 510, 520, 530) gemäß Anspruch 1, wobei das Kommunikationsmodul (110, 310) dazu ausgebildet ist, um das Aktivierungssignal (570) und/oder das Deaktivierungssignal drahtlos zu erhalten; oder
wobei das Kommunikationsmodul (110, 310) dazu ausgebildet ist, um das Aktivierungssignal (570) und/oder das Deaktivierungssignal drahtgebunden zu erhalten.

3. Vorrichtung (100, 200, 300, 302a, 304a, 306a, 410, 420, 430, 510, 520, 530) gemäß einem der vorigen Ansprüche,
wobei das Einkopplungsmodul (140, 240, 342, 342a, 344, 344a, 346, 346a) dazu ausgebildet ist, um im aktiven Betriebsmodus das elektrische Prüfsignal (580) induktiv in die elektrische Leitung (382, 382a, 384, 384a, 386, 388a, 389a) des Objekts (360, 360a, 362a, 372, 372a, 374, 374a, 376, 376a) einzukoppeln; und/oder
wobei das Einkopplungsmodul (140, 240, 342, 342a, 344, 344a, 346, 346a) dazu ausgebildet ist, um im aktiven Betriebsmodus das elektrische Prüfsignal (580) kapazitiv in die elektrische Leitung (382, 382a, 384, 384a, 386, 388a, 389a) des Objekts (360, 360a, 362a, 372, 372a, 374, 374a, 376, 376a) einzukoppeln.

4. Vorrichtung (100, 200, 300, 302a, 304a, 306a, 410, 420, 430, 510, 520, 530) gemäß einem der vorigen Ansprüche, wobei das Einkopplungsmodul (140, 240, 342, 342a, 344, 344a, 346, 346a) dazu ausgebildet ist, galvanisch getrennt, so an der elektrischen Leitung befestigt zu werden, dass die Vorrichtung vor einer Spannungs- und/oder Stromspitze auf der elektrischen Leitung (382, 382a, 384, 384a, 386, 388a, 389a) im Wesentlichen geschützt ist.

5. Vorrichtung (100, 200, 300, 302a, 304a, 306a, 410, 420, 430, 510, 520, 530) gemäß einem der Ansprüche 1 bis 4, wobei das Einkopplungsmodul (140, 240, 342, 342a, 344, 344a, 346, 346a) eine elektrisch schaltbare ohmsche Verbindung mit der Leitung (382, 382a, 384, 384a, 386, 388a, 389a) des Objekts (360, 360a, 362a, 372, 372a, 374, 374a, 376, 376a) aufweist, um im aktiven Betriebsmodus das elektrische Prüfsignal (580) in die elektrische Leitung des Objekts einzukoppeln.

6. Vorrichtung (100, 200, 300, 302a, 304a, 306a, 410, 420, 430, 510, 520, 530) gemäß einem der vorigen Ansprüche, die dazu ausgebildet ist,
um im passiven Betriebsmodus einen Energieverbrauch der Vorrichtung im Vergleich zum aktiven Betriebsmodus zu verringern, und
um das Kommunikationsmodul (110, 310) im passiven Betriebsmodus in zeitlichen Abständen für eine vorbestimmte Dauer zum Erhalten des Aktivierungssignals (570) zu aktivieren.

7. Vorrichtung (100, 200, 300, 302a, 304a, 306a, 410, 420, 430, 510, 520, 530) gemäß einem der vorigen Ansprüche,
wobei die Energiequelle (130, 330, 332, 332a, 334, 334a, 336, 336a) zumindest eines aus einem austauschbaren Energiespeicher und/oder einem wiederaufladbaren Energiespeicher aufweist; und
wobei das Kommunikationsmodul (110, 310) dazu ausgebildet ist, um im aktiven Betriebsmodus einen Ladezustand des Energiespeichers zu übermitteln.

8. Vorrichtung (100, 200, 300, 302a, 304a, 306a, 410, 420, 430, 510, 520, 530) gemäß einem der vorigen Ansprüche, wobei das Kommunikationsmodul (110, 310) dazu ausgebildet ist, um eine Information über den Betriebszustands der Vorrichtung zu übermitteln.

9. Vorrichtung (100, 200, 300, 302a, 304a, 306a, 410, 420, 430, 510, 520, 530) gemäß einem der vorigen Ansprüche, wobei die Vorrichtung zumindest eine Schutzdiode (520) aufweist, und
wobei die Schutzdiode (520) dazu ausgebildet ist, um die Vorrichtung vor einer Spannungs- und/oder Stromspitze auf der elektrischen Leitung (382, 382a, 384, 384a, 386, 388a, 389a) zu schützen.

10. Vorrichtung (100, 200, 300, 302a, 304a, 306a, 410, 420, 430, 510, 520, 530) gemäß einem der vorigen Ansprüche, wobei das Prüfsignal (580) eine aufmodulierte Signalkennung aufweist.

11. Vorrichtung (100, 200, 300, 302a, 304a, 306a, 410, 420, 430, 510, 520, 530) gemäß einem der vorigen Ansprüche,
wobei das Objekt (360, 360a) eine Windkraftanlage mit einer Mehrzahl von Rotorblättern (372, 372a, 374, 374a, 376, 376a) ist, wobei die Rotorblätter jeweils elektrische Leitungen (382, 382a, 384, 384a, 386, 388a, 389a) in Form von Blitzableitern aufweisen; und
wobei die elektrische Leitung ein Blitzableiter eines Rotorblattes der Windkraftanlage ist.

12. System (400, 500) zur Bereitstellung von elektrischen Prüfsignalen (580), zur Durchführung einer Durchgangsprüfung von elektrischen Leitungen (382, 382a, 384, 384a, 386, 388a, 389a) eines Objekts (360, 360a), wobei das Objekt eine Windkraftanlage mit einer Mehrzahl von Rotorblättern (372, 372a, 374, 374a, 376, 376a) ist, wobei die Rotorblätter jeweils elektrische Leitungen in Form von Blitzableitern aufweisen, und wobei das System ferner die folgenden Merkmale umfasst:
eine Mehrzahl von Vorrichtungen (100, 200, 300, 302a, 304a, 306a, 410, 420, 430, 510, 520, 530) gemäß einem der Ansprüche 1 bis 11, wobei ein jeweiliges Einkopplungsmodul (140, 240, 342, 342a, 344, 344a, 346, 346a) einer jeweiligen Vorrichtung dazu ausgebildet ist, um ein jeweiliges elektrisches Prüfsignal zur Durchgangsprüfung eines jeweiligen Blitzableiters in ein jeweiliges Rotorblatt einzukoppeln.

13. System (400, 500) zur Bereitstellung eines elektrischen Prüfsignals (580), zur Durchführung einer Durchgangsprüfung einer elektrischen Leitung (382, 382a, 384, 384a, 386, 388a, 389a) eines Objekts (360, 360a, 362a, 372, 372a, 374, 374a, 376, 376a), umfassend:
eine Vorrichtung (100, 200, 300, 302a, 304a, 306a, 410, 420, 430, 510, 520, 530) gemäß einem der Ansprüche 1 bis 11;
eine Kommunikationseinheit (542, 544, 546), die dazu ausgebildet ist,
um das Aktivierungssignal (570) und das Deaktivierungssignal an das Kommunikationsmodul (110, 310) der Vorrichtung zu übermitteln; und
eine Messeinheit (552, 554, 556), die dazu ausgebildet ist, um das Prüfsignal (580) zu erfassen.

14. System (400, 500) gemäß Anspruch 13, wobei die Kommunikationseinheit dazu ausgebildet ist, um an einer Drohne (562, 564) befestigt zu werden.

15. Verfahren (700) zur Durchführung einer Durchgangsprüfung einer elektrischen Leitung (382, 382a, 384, 384a, 386, 388a, 389a) eines Objekts (360, 360a), umfassend:
Versorgen (710) eines Kommunikationsmoduls (110, 310) mit Energie einer Energiequelle (130, 330, 332, 332a, 334, 334a, 336, 336a); und
Erhalten (720) eines Aktivierungssignals (570) mittels des Kommunikationsmoduls, um ausgehend von einem passiven Betriebsmodus in einen aktiven Betriebsmodus zu wechseln; und
Versorgen (730) eines Signalgenerators (120, 320, 322, 322a, 324, 324a, 326, 326a) im aktiven Betriebsmodus mit Energie der Energiequelle; und
Erzeugen (740) eines elektrischen Prüfsignals (580) im aktiven Betriebsmodus mittels des Signalgenerators; und
Einkoppeln (750) des elektrischen Prüfsignals im aktiven Betriebsmodus in die elektrische Leitung (382, 382a, 384, 384a, 386, 388a, 389a) des Objekts; und
Erhalten (760) eines Deaktivierungssignals mittels des Kommunikationsmoduls, um vom aktiven Betriebsmodus in den passiven Betriebsmodus zu wechseln.

## Claims

1. Device (100, 200, 300, 302a, 304a, 306a, 410, 420, 430, 510, 520, 530) for providing an electrical test signal (580), for performing a continuity test of an electrical line (382, 382a, 384, 384a, 386, 388a, 389a) of an object (360, 360a, 362a, 372, 372a, 374, 374a, 376, 376a), including:
a communication module (110, 310) configured to:
obtain an activation signal (570) to switch the device from a passive operating mode to an active operating mode, and
obtain a deactivation signal to switch the device from the active operating mode to the passive operating mode; and
a signal generator (120, 320, 322, 322a, 324, 324a, 326, 326a) configured to generate the electrical test signal in the active operating mode;
an energy source (130, 330, 332, 332a, 334, 334a, 336, 336a) configured to supply the communication module and the signal generator with energy, and
a coupling-in module (140, 240, 342, 342a, 344, 344a, 346, 346a) configured to:
couple the electrical test signal into the electrical line of the object in the active operating mode.

2. Device (100, 200, 300, 302a, 304a, 306a, 410, 420, 430, 510, 520, 530) according to claim 1, wherein the communication module (110, 310) is configured to obtain the activation signal (570) and/or the deactivation signal in a wireless manner; or
wherein the communication module (110, 310) is configured to obtain the activation signal (570) and/or the deactivation signal in a wired manner.

3. Device (100, 200, 300, 302a, 304a, 306a, 410, 420, 430, 510, 520, 530) according to any of the preceding claims,
wherein the coupling-in module (140, 240, 342, 342a, 344, 344a, 346, 346a) is configured to inductively couple the electrical test signal (580) into the electrical line (382, 382a, 384, 384a, 386, 388a, 389a) of the object (360, 360a, 362a, 372, 372a, 374, 374a, 376, 376a) in the active operating mode; and/or
wherein the coupling-in module (140, 240, 342, 342a, 344, 344a, 346, 346a) is configured to capacitively couple the electrical test signal (580) into the electrical line (382, 382a, 384, 384a, 386, 388a, 389a) of the object (360, 360a, 362a, 372, 372a, 374, 374a, 376, 376a) in the active operating mode.

4. Device (100, 200, 300, 302a, 304a, 306a, 410, 420, 430, 510, 520, 530) according to any of the preceding claims, wherein the coupling-in module (140, 240, 342, 342a, 344, 344a, 346, 346a) is configured to, in a galvanically isolated manner, be attached to the electrical line such that the device is substantially protected from a voltage and/or current spike on the electrical line (382, 382a, 384, 384a, 386, 388a, 389a).

5. The device (100, 200, 300, 302a, 304a, 306a, 410, 420, 430, 510, 520, 530) according to any of claims 1 to 4, wherein the coupling-in module (140, 240, 342, 342a, 344, 344a, 346, 346a) has an electrically switchable ohmic connection with the line (382, 382a, 384, 384a, 386, 388a, 389a) of the object (360, 360a, 362a, 372, 372a, 374, 374a, 376, 376a) in order to couple the electrical test signal (580) into the electrical line of the object in the active operating mode.

6. Device (100, 200, 300, 302a, 304a, 306a, 410, 420, 430, 510, 520, 530) according to any one of the preceding claims, configured to:
reduce energy consumption of the device in the passive operating mode compared to active operating mode, and
activate the communication module (110, 310) in the passive operating mode at time intervals for a predetermined duration for obtaining the activation signal (570).

7. Device (100, 200, 300, 302a, 304a, 306a, 410, 420, 430, 510, 520, 530) according to any of the preceding claims,
wherein the energy source (130, 330, 332, 332a, 334, 334a, 336, 336a) comprises at least one of a replaceable energy storage and/or a rechargeable energy storage; and
wherein the communication module (110, 310) is configured to transmit a charge state of the energy storage in the active operating mode.

8. Device (100, 200, 300, 302a, 304a, 306a, 410, 420, 430, 510, 520, 530) according to any of the preceding claims, wherein the communication module (110, 310) is configured to transmit an information about the operational state of the device.

9. Device (100, 200, 300, 302a, 304a, 306a, 410, 420, 430, 510, 520, 530) according to any of the preceding claims, wherein the device comprises at least one protective diode (520), and
wherein the protective diode (520) is configured to protect the device from a voltage and/or current spike on the electrical line (382, 382a, 384, 384a, 386, 388a, 389a).

10. Device (100, 200, 300, 302a, 304a, 306a, 410, 420, 430, 510, 520, 530) according to any of the preceding claims, wherein the test signal (580) comprises a modulated signal identifier.

11. Device (100, 200, 300, 302a, 304a, 306a, 410, 420, 430, 510, 520, 530) according to any of the preceding claims,
wherein the object (360, 360a) is a wind turbine with a plurality of rotor blades (372, 372a, 374, 374a, 376, 376a), the rotor blades each having electrical lines (382, 382a, 384, 384a, 386, 388a, 389a) in the form of lightning rods; and
where the electrical line is a lightning rod of a rotor blade of the wind turbine.

12. System (400, 500) for providing electrical test signals (580), for performing a continuity test of electrical lines (382, 382a, 384, 384a, 386, 388a, 389a) of an object (360, 360a), wherein the object is a wind turbine with a plurality of rotor blades (372, 372a, 374, 374a, 376, 376a), the rotor blades each having electrical lines in the form of lightning rods, and wherein the system further includes:
a plurality of devices (100, 200, 300, 302a, 304a, 306a, 410, 420, 430, 510, 520, 530) according to any of claims 1 to 17, wherein a respective coupling-in module (140, 240, 342, 342a, 344, 344a, 346, 346a) of a respective device is configured to couple a respective electrical test signal into a respective rotor blade for continuity testing of a respective lightning rod.

13. System (400, 500) for providing an electrical test signal (580), for performing a continuity test of an electrical line (382, 382a, 384, 384a, 386, 388a, 389a) of an object (360, 360a, 362a, 372, 372a, 374, 374a, 376, 376a), including:
a device (100, 200, 300, 302a, 304a, 306a, 410, 420, 430, 510, 520, 530) according to any of claims 1 to 11;
a communication unit (542, 544, 546) configured to:
transmit the activation signal (570) and the deactivation signal to the communication module (110, 310) of the device; and
a measuring unit (552, 554, 556) configured to detect the test signal (580).

14. System (400, 500) according to claim 13, wherein the communication unit is configured to be attached to a drone (562, 564).

15. Method (700) of performing a continuity test of an electrical line (382, 382a, 384, 384a, 386, 388a, 389a) of an object (360, 360a), including:
supplying (710) a communication module (110, 310) with energy of an energy source (130, 330, 332, 332a, 334, 334a, 336, 336a); and
obtaining (720) an activation signal (570) by means of the communication module to switch from a passive operating mode to an active operating mode; and
supplying (730) a signal generator (120, 320, 322, 322a, 324, 324a, 326, 326a) with energy of the energy source in the active operating mode; and
generating (740) an electrical test signal (580) by means of the signal generator in the active operating mode; and
coupling (750) the electrical test signal into the electrical line (382, 382a, 384, 384a, 386, 388a, 389a) of the object in the active operating mode; and
obtaining (760) a deactivation signal by means of the communication module to switch from active operating mode to passive operating mode.

## Revendications

1. Dispositif (100, 200, 300, 302a, 304a, 306a, 410, 420, 430, 510, 520, 530) pour fournir un signal de contrôle électrique (580), pour effectuer un contrôle de continuité sur une ligne électrique (382, 382a, 384, 384a, 386, 388a, 389a) d'un objet (360, 360a, 362a, 372, 372a, 374, 374a, 376, 376a), comprenant :
un module de communication (110, 310), qui est conçu
pour obtenir un signal d'activation (570) afin de faire passer le dispositif d'un mode de fonctionnement passif à un mode de fonctionnement actif, et
pour obtenir un signal de désactivation afin de faire passer le dispositif du mode de fonctionnement actif au mode de fonctionnement passif ; et
un générateur de signal (120, 320, 322, 322a, 324, 324a, 326, 326a) qui est conçu pour générer le signal de contrôle électrique dans le mode de fonctionnement actif ;
une source d'énergie (130, 330, 332, 332a, 334, 334a, 336, 336a) qui est conçue pour alimenter en énergie le module de communication et le générateur de signal, et
un module d'injection (140, 240, 342, 342a, 344, 344a, 346, 346a) qui est conçu
pour injecter le signal de contrôle électrique dans la ligne électrique de l'objet dans le mode de fonctionnement actif.

2. Dispositif (100, 200, 300, 302a, 304a, 306a, 410, 420, 430, 510, 520, 530) selon la revendication 1, dans lequel le module de communication (110, 310) est conçu pour obtenir le signal d'activation (570) et/ou le signal de désactivation par une liaison sans fil, ou
dans lequel le module de communication (110, 310) est conçu pour obtenir le signal d'activation (570) et/ou le signal de désactivation par une liaison filaire.

3. Dispositif (100, 200, 300, 302a, 304a, 306a, 410, 420, 430, 510, 520, 530) selon l'une des revendications précédentes,
dans lequel le module d'injection (140, 240, 342, 342a, 344, 344a, 346, 346a) est conçu pour injecter le signal de contrôle électrique (580) de manière inductive dans la ligne électrique (382, 382a, 384, 384a, 386, 388a, 389a) de l'objet (360, 360a, 362a, 372, 372a, 374, 374a, 376, 376a) dans le mode de fonctionnement actif ; et/ou
dans lequel le module d'injection (140, 240, 342, 342a, 344, 344a, 346, 346a) est conçu pour injecter le signal de contrôle électrique (580) de manière capacitive dans la ligne électrique (382, 382a, 384, 384a, 386, 388a, 389a) de l'objet (360, 360a, 362a, 372, 372a, 374, 374a, 376, 376a) dans le mode de fonctionnement actif.

4. Dispositif (100, 200, 300, 302a, 304a, 306a, 410, 420, 430, 510, 520, 530) selon l'une des revendications précédentes,
dans lequel le module d'injection (140, 240, 342, 342a, 344, 344a, 346, 346a) est conçu pour être fixé à la ligne électrique de manière isolée galvaniquement de telle sorte que le dispositif soit sensiblement protégé contre une pointe de tension et/ou de courant sur la ligne électrique (382, 382a, 384, 384a, 386, 388a, 389a).

5. Dispositif (100, 200, 300, 302a, 304a, 306a, 410, 420, 430, 510, 520, 530) selon l'une des revendications 1 à 4, dans lequel le module d'injection (140, 240, 342, 342a, 344, 344a, 346, 346a) présente une connexion ohmique commutable électriquement avec la ligne (382, 382a, 384, 384a, 386, 388a, 389a) de l'objet (360, 360a, 362a, 372, 372a, 374, 374a, 376, 376a) afin d'injecter le signal de contrôle électrique (580) dans la ligne électrique de l'objet dans le mode de fonctionnement actif.

6. Dispositif (100, 200, 300, 302a, 304a, 306a, 410, 420, 430, 510, 520, 530) selon l'une des revendications précédentes, qui est conçu
pour réduire la consommation d'énergie du dispositif dans le mode de fonctionnement passif par rapport au mode de fonctionnement actif, et
pour activer le module de communication (110, 310) dans le mode de fonctionnement passif dans des intervalles de temps pendant une durée prédéterminée pour obtenir le signal d'activation (570).

7. Dispositif (100, 200, 300, 302a, 304a, 306a, 410, 420, 430, 510, 520, 530) selon l'une des revendications précédentes,
dans lequel la source d'énergie (130, 330, 332, 332a, 334, 334a, 336, 336a) présente au moins un accumulateur d'énergie remplaçable et/ou un accumulateur d'énergie rechargeable ; et
dans lequel le module de communication (110, 310) est conçu pour transmettre un état de charge de l'accumulateur d'énergie dans le mode de fonctionnement actif.

8. Dispositif (100, 200, 300, 302a, 304a, 306a, 410, 420, 430, 510, 520, 530) selon l'une des revendications précédentes, dans lequel le module de communication (110, 310) est conçu pour transmettre une information sur l'état de fonctionnement du dispositif.

9. Dispositif (100, 200, 300, 302a, 304a, 306a, 410, 420, 430, 510, 520, 530) selon l'une des revendications précédentes, dans lequel le dispositif présente au moins une diode de protection (520), et
dans lequel la diode de protection (520) est conçue pour protéger le dispositif d'un pic de tension et/ou de courant sur la ligne électrique (382, 382a, 384, 384a, 386, 388a, 389a).

10. Dispositif (100, 200, 300, 302a, 304a, 306a, 410, 420, 430, 510, 520, 530) selon l'une des revendications précédentes, dans lequel le signal de contrôle (580) présente un identifiant de signal modulé.

11. Dispositif (100, 200, 300, 302a, 304a, 306a, 410, 420, 430, 510, 520, 530) selon l'une des revendications précédentes,
dans lequel l'objet (360, 360a) est une éolienne avec une pluralité de pales de rotor (372, 372a, 374, 374a, 376, 376a), dans lequel les pales de rotor présentent chacune des lignes électriques (382, 382a, 384, 384a, 386, 388a, 389a) sous la forme de paratonnerres ; et
dans lequel la ligne électrique est un paratonnerre d'une pale de rotor de l'éolienne.

12. Système (400, 500) pour fournir des signaux de contrôle électriques (580), pour effectuer un contrôle de continuité sur des lignes électriques (382, 382a, 384, 384a, 386, 388a, 389a) d'un objet (360, 360a), dans lequel l'objet est une éolienne avec une pluralité de pales de rotor (372, 372a, 374, 374a, 376, 376a), dans lequel le système comprend en outre les caractéristiques suivantes :
une pluralité de dispositifs (100, 200, 300, 302a, 304a, 306a, 410, 420, 430, 510, 520, 530) selon l'une des revendications 1 à 11, dans lequel un module d'injection respectif (140, 240, 342, 342a, 344, 344a, 346, 346a) d'un dispositif respectif est conçu pour injecter dans une pale de rotor respective un signal de contrôle électrique respectif pour le contrôle de continuité d'un paratonnerre respectif.

13. Système (400, 500) pour fournir un signal de contrôle électrique (580), pour effectuer un contrôle de continuité sur une ligne électrique (382, 382a, 384, 384a, 386, 388a, 389a) d'un objet (360, 360a, 362a, 372, 372a, 374, 374a, 376, 376a), comprenant :
un dispositif (100, 200, 300, 302a, 304a, 306a, 410, 420, 430, 510, 520, 530) selon l'une des revendications 1 à 11 ;
une unité de communication (542, 544, 546) qui est conçue
pour transmettre le signal d'activation (570) et le signal de désactivation au module de communication (110, 310) du dispositif ; et
une unité de mesure (552, 554, 556) qui est conçue pour détecter le signal de contrôle (580).

14. Système (400, 500) selon la revendication 13, dans lequel l'unité de communication est conçue pour être fixée à un drone (562, 564).

15. Procédé (700) pour effectuer un contrôle de continuité sur une ligne électrique (382, 382a, 384, 384a, 386, 388a, 389a) d'un objet (360, 360a), comprenant :
alimenter en énergie (710) un module de communication (110, 310) à partir d'une source d'énergie (130, 330, 332, 332a, 334, 334a, 336, 336a) ; et
obtenir (720) un signal d'activation (570) à l'aide du module de communication afin de passer d'un mode de fonctionnement passif à un mode de fonctionnement actif ; et
alimenter en énergie (730) un générateur de signal (120, 320, 322, 322a, 324, 324a, 326, 326a) dans le mode de fonctionnement actif à partir de la source d'énergie ; et
générer (740) un signal de contrôle électrique (580) dans le mode de fonctionnement actif à l'aide du générateur de signal ; et
injecter (750) le signal de contrôle électrique dans la ligne électrique (382, 382a, 384, 384a, 386, 388a, 389a) de l'objet dans le mode de fonctionnement actif ; et
obtenir (760) un signal de désactivation à l'aide du module de communication afin de passer du mode de fonctionnement actif au mode de fonctionnement passif.
